(19) Europäisches Patentamt
European Patent Office
Office européen des brevets

(11) EP 2 363 869 A2

(12) **EUROPEAN PATENT APPLICATION**

(43) Date of publication:
**07.09.2011 Bulletin 2011/36**

(51) Int Cl.:
***H01G 9/20*** *(2006.01)* *H01L 51/00* *(2006.01)*

(21) Application number: **11155348.3**

(22) Date of filing: **22.02.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **05.03.2010 JP 2010049765**
**15.07.2010 JP 2010160585**

(71) Applicant: **Sony Corporation**
**Tokyo 108-0075 (JP)**

(72) Inventors:
- **Tsuda, Ryohei**
  **Tokyo 108-0075 (JP)**
- **Suzuki, Yusuke**
  **Tokyo 108-0075 (JP)**

(74) Representative: **Malden, Nicholas**
**D Young & Co LLP**
**120 Holborn**
**London EC1N 2DY (GB)**

(54) **Photoelectric conversion element and method of manufacturing the same, and electronic apparatus**

(57) Photoelectric conversion elements and electrolyte solutions suitable for various applications and related components, and methods associated therewith, are described. Photoelectric conversion elements may include an electrolyte solution including an ionic liquid and an organic solvent. The ionic liquid may have an electron pair accepting functional group and the organic solvent may have an electron pair donating functional group. In some cases, including specified amounts of certain ionic liquids and organic solvents together may result in an electrolyte solution providing for advantageous photoelectric conversion efficiency while exhibiting low volatility.

FIG. 1

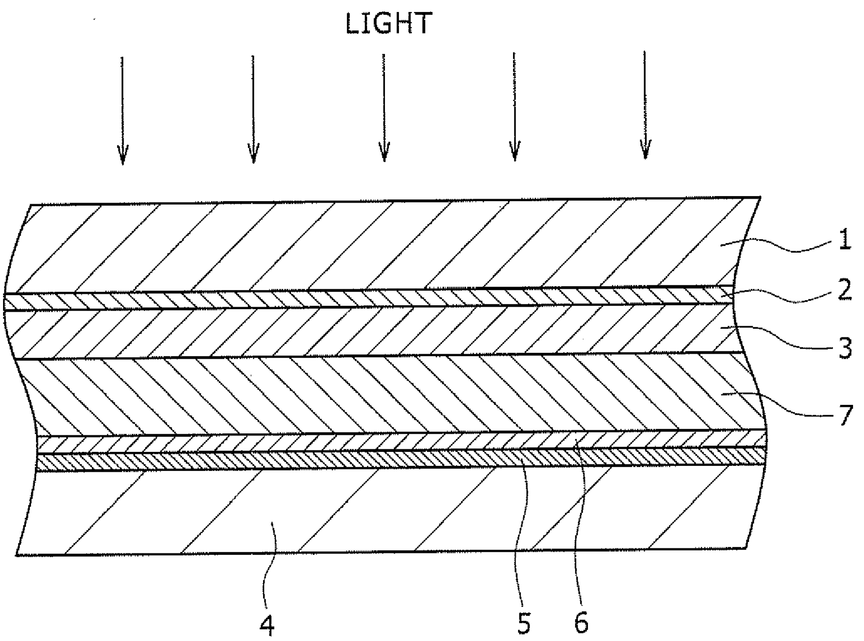


EP 2 363 869 A2

## Description

The present invention relates to a photoelectric conversion element and a method of manufacturing the same, and an electronic apparatus. More particularly the invention relates to a photoelectric conversion element which is preferable for application to, for example, a dye-sensitized solar cell, a method of manufacturing the photoelectric conversion element, and an electronic apparatus using the photoelectric conversion element.

The solar cell (battery), which is a photoelectric conversion element for converting sunlight into electrical energy, uses the sunlight as an energy source and, therefore, it has very little influence on the global environment. Accordingly, a further spread of the solar cells (batteries) is now being expected.

As the solar cell, crystalline silicon solar cells, using single-crystal or polycrystalline silicon, and amorphous silicon solar cells have been mainly used.

On the other hand, a dye-sensitized solar cell proposed by Graetzel et al in 1991 has been paid attention to, since it offers a high photoelectric conversion efficiency and, unlike the silicon solar cells in the past, it can be manufactured at low cost without needing a large-scale equipment (see, for example, Nature, 353, p.737-740, 991).

The dye-sensitized solar cell, in general, has a structure in which a porous photoelectrode having titanium oxide or the like with a photosensitizing dye bonded thereto and a counter electrode having platinum or the like are opposed to each other, and the space between the electrodes is filled with an electrolyte layer having an electrolyte solution. As the electrolyte solution, those in which an electrolyte containing oxidation-reduction species such as iodine and iodide ion is dissolved in a solvent are often used.

As the solvent of the electrolyte solution in the dye-sensitized solar cells, volatile organic solvents such as acetonitrile have been used. In such a dye-sensitized solar cell, however, there arises the problem that if the electrolyte solution is exposed to the atmospheric air due to breakage of the cell or the like, transpiration of the electrolyte solution would occur, leading to a failure of the cell.

In order to solve this problem, in recent years, difficultly volatilizable molten salts called ionic liquids have come to be used in place of the volatile organic solvents as the solvent of the electrolyte solution (see, for example, JP-T-2009-527074 and Inorg. Chem. 1996, 35, 1168-1178 and J. Chem. Phys. 124, 184902 (2006)). As a result, the problem of volatilization (evaporation) of the electrolyte solutions in the dye-sensitized solar cells has been improved.

However, ionic liquids have viscosity coefficients much higher than those of the organic solvents used in the past. In practice, therefore, the dye-sensitized solar cells using ionic liquid are poorer in photoelectric conversion characteristics than the other dye-sensitized solar cells in the past.

Thus, there is a need for a photoelectric conversion element, such as a dye-sensitized solar cell, in which volatilization (evaporation) of electrolyte solution can be restrained and excellent photoelectric conversion characteristics can be obtained, and a method of manufacturing the same.

Also, there is a need for a high-performance electronic apparatus in which the excellent photoelectric conversion element as just-mentioned is used.

The present inventors made intensive and extensive investigations in order to meet the above-mentioned needs. In the course of their studies, the present inventors, in searching for a measure to improve the problem of degradation of photoelectric conversion characteristics in using an ionic liquid as the solvent of the electrolyte solution, made an attempt to dilute the ionic liquids with volatile organic solutions, while presupposing that no improving effect would thereby be obtainable. The results were as presupposed. Specifically, it was found that, when a solvent obtained by diluting an ionic liquid with a volatile organic solvent is used as the solvent of the electrolyte solution in the above-mentioned dye-sensitized solar cell, the problem of volatilization of the organic solvent would remain unsolved, although photoelectric conversion characteristics are enhanced owing to a lowering in the viscosity coefficient of the electrolyte solution.

However, as a result of their further trial to dilute ionic liquids with various organic solvents in order to advance the above-mentioned verification, the present inventors found out that it is possible, by use of specific combinations of ionic liquid with organic solvent, to effectively suppress the volatilization of the electrolyte solution without deteriorating the photoelectric conversion characteristics. This was an unexpected, astonishing result. Based on this unexpected finding, the present inventors carried out further experimental and theoretical investigations. As a result, they reached the conclusion that it is effective, in overcoming the above-mentioned problem, to incorporate in the solvent of the electrolyte solution an ionic liquid having an electron pair accepting functional group and an organic solvent having an electron pair donating functional group. Aspects of the inventors' discovery are presented herein.

In each of the embodiments described herein, the "ionic liquid" includes not only those salts which are in a liquid state at 100°C (inclusive of those salts which come to be in a liquid state at room temperature through supercooling although the melting point or glass transition temperature thereof is not less than 100°C) but also those salts which, when a solvent is added thereto, forms at least one phase and comes to be in a liquid state. The ionic liquid may basically be any ionic liquid that has an electron accepting functional group such as an electron pair accepting functional group, and the organic solvent may fundamentally be any organic solvent that has an electron donating functional group such

as an electron pair donating functional group. The ionic liquid may be one in which a cation has an electron pair accepting functional group. The ionic liquid may include an organic cation which includes an aromatic amine cation having a quaternary nitrogen atom and which has a hydrogen atom in an aromatic ring, and an anion having a van der Waals volume of not less than 76 $Å^3$ (the anion includes not only organic anions but also inorganic anions such as $AlCl_4^-$ and $FeCl_4^-$), but this configuration is not limitative. The content of the ionic liquid in the solvent is selected as required. Preferably, however, the solvent including the ionic liquid and the organic solvent contains the ionic liquid in an amount of not less than 15 wt% and less than 100 wt%. The electron donating functional group of the organic solvent may be an electron pair donating functional group such as an ether group or an amino group, but this is not limitative.

The electrolyte solution prepared using the ionic liquid having an electron pair accepting functional group and the organic solvent having an electron pair donating functional group may be in a gelled state.

The photoelectric conversion element, typically, is a dye-sensitized photoelectric conversion element in which a photosensitizing dye is bonded to (or adsorbed on) a porous photoelectrode. In this case, preferably, the method of manufacturing the photoelectric conversion element further includes a step of bonding a photosensitizing dye to the porous photoelectrode. The porous photoelectrode may include particulates having a semiconductor. The semiconductor, typically, has titanium oxide ($TiO_2$), especially, anatase-type $TiO_2$

As the porous photoelectrode, one including particulates of the so-called core-shell structure may be used, and, in this case, it is unnecessary to bond a photosensitizing dye to the porous photoelectrode. As the porous photoelectrode, preferably, one that has particulates which each include a core having a metal and a shell having a metal oxide surrounding the core is used. The use of such a porous photoelectrode ensures that when the electrolyte layer is fillingly disposed between the porous photoelectrode and the counter electrode, the electrolyte of the electrolyte layer is prevented from making contact with the metal cores of the metal-metal oxide particulates, so that dissolution of the porous photoelectrode by the electrolyte can be prevented from occurring. Therefore, as the metal constituting the cores of the metal-metal oxide particulates, there can be used those metals which show an effect of surface plasmon resonance and which have been difficult to use in the related art, such as gold (Au), silver (Ag) and copper (Cu). Consequently, the effect of the surface plasmon resonance can be sufficiently obtained in photoelectric conversion. In addition, an iodine-based electrolyte can be used as the electrolyte of the electrolyte layer. Besides, platinum (Pt), palladium (Pd) and the like can also be used as the metal constituting the cores of the metal-metal oxide particulates. On the other hand, as the metal oxide constituting the shells of the metal-metal oxide particulates, a metal oxide which is not dissolved in the electrolyte is used, and is selected as required. Preferably, the metal oxide is at least one metal oxide selected from the group consisting of titanium oxide ($TiO_2$), tin oxide ($SnO_2$), niobium oxide ($Nb_2O_5$) and zinc oxide (ZnO). These metal oxides, however, are not limitative. For instance, such metal oxides as tungsten oxide ($WO_3$) and strontium titanate ($SrTiO_3$) can also be used. The particle diameter of the metal-metal oxide particulates is selected as required, and, preferably, it is in the range of 1 to 500 nm. Besides, the particle diameter of the cores of the metal-metal oxide particulates is also selected as required, and, preferably, it is in the range of 1 to 200 nm.

The photoelectric conversion element, most typically, is configured as a solar cell. It is to be noted here, however, that the photoelectric conversion element may be other than the solar cell; for example, the photoelectric conversion element may be a photosensor or the like.

The electronic apparatus, basically, may be any of electronic apparatuses inclusive of portable-type ones and stationary-type ones. Specific examples of the electronic apparatus include cell phones, mobile apparatuses, robots, personal computers, on-vehicle apparatuses, and a variety of household electrical appliances. In this case, the photoelectric conversion element is, for example, a solar cell to be used as a power source in these electronic apparatuses.

In the embodiments of the present invention described herein, a hydrogen bond is formed between an electron pair accepting functional group of the ionic liquid and an electron pair donating functional group of the organic solvent, in the solvent of the electrolyte solution. Through the hydrogen bond, the molecule of the ionic liquid and the molecule of the organic solvent are bonded to each other. Therefore, volatilization of the organic solvent and, hence, volatilization of the electrolyte solution can be suppressed, as compared with the case where the organic solvent is used alone. Besides, since the solvent of the electrolyte solution contains the organic solvent in addition to the ionic liquid, the viscosity coefficient of the electrolyte solution can be lowered, as compared with the case where the ionic liquid is used alone as the solvent. Consequently, deterioration of photoelectric conversion characteristics due to the high viscosity coefficient of the ionic liquid can be obviated.

According to the embodiments of the present invention, it is possible to realize a photoelectric conversion element in which volatilization (evaporation) of an electrolyte solution can be restrained and excellent photoelectric conversion characteristics can be obtained. Then, by use of the excellent photoelectric conversion element, it is possible to realize a high-performance electronic apparatus.

Further particular and preferred aspects of the present invention are set out in the accompanying independent and dependent claims. Features of the dependent claims may be combined with features of the independent claims as appropriate, and in combinations other than those explicitly set out in the claims.

The present invention will be described further, by way of example only, with reference to preferred embodiments

thereof as illustrated in the accompanying drawings, in which:

FIG. 1 is a sectional view illustrating a dye-sensitized photoelectric conversion element according to a first embodiment of the present invention;
FIG 2 is a schematic diagram illustrating the principle of operation of the dye-sensitized photoelectric conversion element according to the first embodiment of the invention;
FIG. 3 shows the structural formula of Z907;
FIG. 4 is a schematic diagram showing the measurement results of IPCE spectrum for a dye-sensitized photoelectric conversion element in which Z907 alone was bonded to a porous photoelectrode;
FIG. 5 shows the structural formula of Dye A;
FIG. 6 is a schematic diagram showing the measurement results of IPCE spectrum for a dye-sensitized photoelectric conversion element in which Dye A alone was bonded to a porous photoelectrode;
FIG 7 shows the structural formula of Z991;
FIG. 8 is a schematic diagram showing the results of TG-DTA measurement for various solvents;
FIG. 9 is a schematic diagram showing the results of TG-DTA measurement for various solvents;
FIG. 10 is a schematic diagram showing the results of TG-DTA measurement for various solvents;
FIG. 11 is a schematic diagram showing the results of TG-DTA measurement for various solvents;
FIG. 12 is a schematic diagram showing the results of an acceleration test for the dye-sensitized photoelectric conversion elements according to the first embodiment of the invention;
FIG. 13 is a schematic diagram showing the results of measurement of the relationship between the content of EMImTCB, in a mixed solvent of EMImTCB and triglyme, and evaporation rate lowering ratio;
FIG. 14 is a schematic diagram showing the results of measurement of the relationship between the van der Waals volume of anion, in various ionic liquids, and evaporation rate lowering ratio;
FIG. 15 is a schematic diagram illustrating the manner in which a hydrogen bond is formed between an ionic liquid having an electron pair accepting functional group and an organic solvent having an electron pair donating functional group;
FIG. 16 is a schematic diagram illustrating the manner in which a plurality of hydrogen bonds are formed between an ionic liquid having electron pair accepting functional groups and an organic solvent having a plurality of electron pair donating functional groups;
FIG. 17 is a sectional view illustrating a dye-sensitized photoelectric conversion element according to a second embodiment of the invention;
FIG. 18 is a sectional view illustrating the configuration of each of metal-metal oxide particulates constituting a porous photoelectrode in the dye-sensitized photoelectric conversion element according to the second element of the invention; and
FIG. 19 is a sectional view illustrating a photoelectric conversion element according to a third embodiment of the invention.

Now, example modes for carrying out the present invention (hereinafter referred to as "embodiments") will be described below. The description will be made in the following order.

1. First Embodiment (Dye-sensitized photoelectric conversion element and method of manufacturing the same)
2. Second Embodiment (Dye-sensitized photoelectric conversion element and method of manufacturing the same)
3. Third Embodiment (Photoelectric conversion element and method of manufacturing the same)

<1. First Embodiment>

[Dye-sensitized photoelectric conversion element]

FIG. 1 is an essential-part sectional view illustrating a dye-sensitized photoelectric conversion element according to a first embodiment of the present invention.
As shown in FIG. 1, the dye-sensitized photoelectric conversion element has a configuration in which a transparent electrode 2 is provided on a principal surface of a transparent substrate 1, and a porous photoelectrode 3 is provided on the transparent electrode 2. One kind or plural kinds of photosensitizing dyes (not shown) are bonded to the porous photoelectrode 3. On the other hand, a transparent conductor layer 5 is provided on a principal surface of a counter substrate 4, and a counter electrode 6 is provided on the transparent conductor layer 5. In addition, an electrolyte layer 7 having an electrolyte solution is provided, in a filling manner, between the porous photoelectrode 3 over the transparent substrate 1 and the counter electrode 6 over the counter substrate 4, and peripheral portions of the transparent substrate 1 and the counter substrate 4 are sealed with a sealing member (not shown).

As the porous photoelectrode 3, typically, a porous semiconductor layer formed by sintering semiconductor particulates is used. The photosensitizing dye(s) is adsorbed on the surfaces of the semiconductor particulates. As material for the semiconductor particulates, there can be used elemental semiconductors represented by silicon, compound semiconductors, semiconductors having a perovskite structure, and the like. These semiconductors, preferably, are n-type semiconductors in which conduction-band electrons become carriers under photoexcitation, thereby generating an anode current. Specific examples of the semiconductor include titanium oxide ($TiO_2$) zinc oxide (ZnO), tungsten oxide ($WO_3$), niobium oxide ($Nb_2O_5$), strontium titanate ($SrTiO_3$), and tin oxide ($SnO_2$). Among these semiconductors, preferred is $TiO_2$, particularly, anatase-type $TiO_2$ It is to be noted here, however, that the semiconductor is not limited to the just-mentioned and, if necessary, two or more kinds of semiconductors can be used as a mixture or as a composite material. Besides, the shape of the semiconductor particulates may be any of such shapes as granular (particulate), tubular, spherical and rod-like shapes.

The particle diameter of the semiconductor particulates is not particularly limited, and it is preferably in the range of 1 to 500 nm, or 1 to 200 nm, more preferably 5 to 100 nm, in terms of average particle diameter of primary particles. Besides, it is possible to admix the semiconductor particulates with particles greater in size than the semiconductor particulates so that incident light is scattered by the particles, thereby enhancing quantum yield. In this case, the average size of the particles with which the semiconductor particulates are admixed is preferably in the range of 20 to 500 nm, which is not limitative.

The porous photoelectrode 3, preferably, is large in actual (total) surface area inclusive of the particulate surfaces exposed to the pores in the inside of the porous semiconductor layer having the semiconductor particulates, in order that as much as possible of the photosensitizing dye(s) can be bonded to the porous photoelectrode 3. From this point of view, the actual surface area of the porous photoelectrode 3 in the state of being formed on the transparent electrode 2 is preferably not less than 10 times, more preferably, not less than 100 times the outside surface area (projection area) of the porous photoelectrode 3. The value of this ratio does not have a specific upper limit; usually, however, the actual surface area is up to about 1000 times the outside surface area.

In general, as the thickness of the porous photoelectrode 3 increases and the number of the semiconductor particulates contained in unit projection area increases, the actual surface area is increased and the amount of the photosensitizing dye(s) that can be held in the unit projection area is increased, leading to an increased light absorptivity. On the other hand, an increase in the thickness of the porous photoelectrode 3 leads to an increase in the distance the electrons transferred from the photosensitizing dye to the porous photoelectrode 3 have to travel (diffuse) before reaching the transparent electrode 2, which, in turn, leads to an increase in the loss of electrons due to recombination of electric charges in the porous photoelectrode 3. In view of these points, there is a preferable thickness for the porous photoelectrode 3. The thickness is generally 0.1 to 100 $\mu$m, preferably 1 to 50 $\mu$m, or more preferably 3 to 30 $\mu$m.

Examples of the electrolyte solution constituting the electrolyte layer 7 include solutions that contain an oxidation-reduction system (redox system). Specifically, a combination of iodine ($I_2$) with a iodide salt of a metal or organic substance, a combination of bromine ($Br_2$) with a bromide salt of a metal or organic substance, or the like may be used. Examples of the cation constituting the metallic salt include lithium ($Li^+$), sodium ($Na^+$), potassium ($K^+$), cesium ($Cs^+$), magnesium ($Mg^{2+}$), and calcium ($Ca^{2+}$). On the other hand, preferable examples of the cation constituting the organic substance salt include quaternary ammonium ions such as tetraalkylammonium ions, pyridinium ions, and imidazolium ions, which may be used either singly or in mixture of two or more of them.

As the electrolyte solution constituting the electrolyte layer 7, other ones than the above-mentioned can also be used. The other ones include: metal complexes such as a combination of a ferrocyanate with a ferricyanate, a combination of ferrocene with ferricinium ion, etc.; sulfur compounds such as sodium polysulfide, a combination of an alkyl thiol with an alkyl disulfide, etc.; viologen dyes; a combination of hydroquinone with quinone, etc.

Among the above-mentioned electrolytes for constituting the electrolyte layer 7, particularly preferred electrolytes are combinations of iodine ($I_2$) with lithium iodide (LiI), sodium iodide (NaI) or such a quaternary ammonium compound as imidazolium iodide. The concentration of the electrolyte salt based on the amount of solvent is preferably 0.05 to 10 M, more preferably 0.2 to 3 M. The concentration of iodine ($I_2$) or bromine ($Br_2$) is preferably 0.0005 to 1 M, more preferably 0.001 to 0.5 M.

In this case, as the solvent of the electrolyte solution constituting the electrolyte layer 7, there is used a solvent which contains at least an ionic liquid having an electron pair accepting functional group and an organic solvent having an electron pair donating functional group. Typically, the electron pair accepting functional group is possessed by a cation constituting the ionic liquid. Embodiments of the electrolyte solution may also include an ionic liquid having an electron accepting functional group and an organic solvent having an electron donating functional group. The cation in the ionic liquid is preferably an organic cation which includes an aromatic amine cation having a quaternary nitrogen atom and which has a hydrogen atom in an aromatic ring. Non-limitative examples of the organic cation include imidazolium cation, pyridinium cation, thiazolium cation, and pyrazolium cation. As an anion in the ionic liquid, preferably, there is used an anion which has a van der Waals volume of not less than 76 Å$^3$, more preferably not less than 100 Å$^3$.

The electrolyte solution having an ionic liquid and an organic solvent may include the ionic liquid in an amount

of at least 15 wt%, less than 100 wt%, or between about 15 wt% and about 50 wt% of the electrolyte solution.

Specific examples of the ionic liquid having an electron pair accepting functional group include the following.

·EMImTCB: 1-ethyl-3-methylimidazolium tetracyanoborate
·EMImTFSI: 1-ethyl-3-methylimidazolium bis(trifluoromethanesulfone)imide
.EMImFAP: 1-ethyl-3-methylimidazolium tris(pentafluoroethyl)trifluorophosphate
·$EMImBF_4$: 1-ethyl-3-methylimidazolium tetrafluoroborate

From the viewpoint of lowering the evaporation rate, the organic solvent having an electron pair donating functional group preferably has one of the following chemical structures, which are not limitative.

·Ether

[Chemical 1]

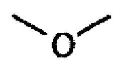

·Ketone

[Chemical 2]

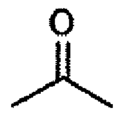

·Amine structure
Primary amine

$— NH_2$. [Chemical 3]

Tertiary amine

[Chemical 4]

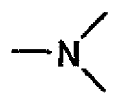

·Aromatic amine
Pyridine structure

[Chemical 5]

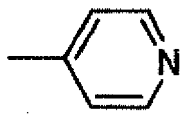

Imidazole structure

[Chemical 6]

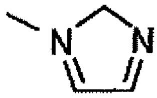

·Sulfone

[Chemical 7]

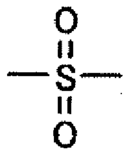

·Sulfoxide

[Chemical 8]

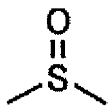

Specific examples of the organic solvent having an electron pair donating functional group include the following.

-MPN: 3-methoxypropionitrile
·GBL: γ-butyrolactone
·DMF: N,N-dimethylformamide
·diglyme: diethylene glycol dimethyl ether
·triglyme: triethylene glycol dimethyl ether
·tetraglyme: tetraethylene glycol dimethyl ether
·PhOAN: phenoxy acetonitrile
·PC: propylene carbonate
·aniline: aniline
·DManiline: N,N-dimethylaniline
·NBB: N-butylbenzimidazole
·TBP: tert-butylpyridine

·EMS: ethyl methyl sulfone
·DMSO: dimethyl sulfoxide

Specific examples of the organic solvent having a tertiary nitrogen atom, when classified into five groups, include the following.

(1) methylamine, dimethylamine, trimethylamine, ethylamine, diethylamine, triethylamine, ethylmethylamine, n-propylamine, iso-propylamine, dipropylamine, n-butylamine, sec-butylamine, tert-butylamine
(2) ethylenediamine
(3) aniline, N,N-dimethylaniline
(4) formamide, N-methylformamide, N,N-dimethylforamide, acetamide, N-methylacetamide, N,N-dimethylacetamide
(5) N-methylpyrrolidone

Representing (1) to (4) in a general formula, the compounds or molecules belonging to these groups are those organic molecules of a molecular weight of not more than 1000 which have the following molecular skeleton:

[Chemical 9]

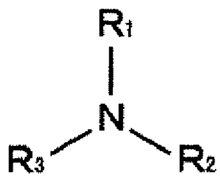

where $R_1$, $R_2$ and $R_3$ are each a substituent group selected from the group consisting of H, $C_nH_m$ (n = 1 to 20, m = 3 to 41), phenyl group, aldehyde group and acetyl group.

The transparent substrate 1 is not specifically restricted insofar as its material and shape permit light to easily pass therethrough, and various substrate materials can be used for the transparent substrate 1. It is preferable, however, to use a substrate material which has a high visible-light transmittance. In addition, preferably, the material has a high barrier property for inhibiting water vapor and other gases from externally penetrating into the dye-sensitized photoelectric conversion element, and is excellent in chemical resistance and weatherability. Specific examples of the material which can be used to form the transparent substrate 1 include transparent inorganic materials such as quartz, glass, etc. and transparent plastics such as polyethylene terephthalate, polyethylene naphthalate, polycarbonate, polystyrene, polyethylene, polypropylene, polyphenylene sulfide, polyvinylidene fluoride, acetyl cellulose, phenoxy bromide, aramides, polyimides, polystyrenes, polyarylates, polysulfones, polyolefins, etc. The thickness of the transparent substrate 1 is not particularly limited, and can be selected as required, taking into account the light transmittance and the barrier performance for shielding the inside and the outside of the photoelectric conversion element from each other.

The transparent electrode 2 provided on the transparent substrate 1 is more desirable as its sheet resistance is lower. Specifically, the sheet resistance is preferably not more than 500 Ω/□, more preferably not more than 100 Ω/□. The material for forming the transparent electrode 2 may be selected, as required, from known materials. Specific examples of the material which can be used to form the transparent electrode 2 include indium-tin composite oxide (ITO), fluorine-doped tin(IV) oxide $SnO_2$ (FTO), tin(IV) oxide $SnO_2$, zinc(II) oxide ZnO, and indium-zinc composite oxide (IZO). It should be noted here, however, that the material for the transparent electrode 2 is not limited to these materials; besides, two or more of them may also be used in combination.

The photosensitizing dye bonded to the porous photoelectrode 3 is not particularly limited insofar as it exhibits a sensitizing action. Preferably, however, the photosensitizing dye has an acid functional group which enables adsorption of the dye onto the surface of the porous photoelectrode 3. In general, photosensitizing dyes having a carboxyl group or a phosphoric acid group or the like are preferable; among them, particularly preferred are those having a carboxyl group. Specific examples of the photosensitizing dyes include xanthene dyes such as Rhodamine B, Rose Bengale, eosine, erythrosine, etc., cyanine dyes such as merocyanine, quinocyanine, cryptocyanine, etc., basic dyes such as phenosafranine, Cabri blue, thiocine, Methylene Blue, etc., and porphyrin compounds such as chlorophyll, zinc porphyrin,

magnesium porphyrin, etc. Other examples than the just-mentioned include azo dyes, phthalocyanine compounds, cumarin compounds, bipyridine complex compounds, anthraquinone dyes, polycyclic quinone dyes, and so on. Among these dyes, those complexes of at least one metal selected from Ru, Os, Ir, Pt, Co, Fe, and Cu in which a ligand includes a pyridine ring or an imidazolium ring are preferred because of their high quantum yield. Especially, dye molecules having cis-bis(isothiocyanato)-N,N-bis(2,2'-dipyridyl-4,4'-dicarboxylic acid)-ruthenium(II) or tris(isothiocyanato)-ruthenium(II)-2,2':6',2'-terpyridine-4,4',4"-tricarboxylic acid as a basic skeleton are preferred because of their wide absorption wavelength region. It should be noted here, however, that the photosensitizing dye is not restricted to these dyes. As the photosensitizing dye, typically, one of these dyes is used, but two or more of the photosensitizing dyes may also be used in mixture. In the case where two or more photosensitizing dyes are used in mixture, the photosensitizing dyes preferably include an inorganic complex dye which has a property of causing MLCT (Metal to Ligand Charge Transfer) and which is held on the porous photoelectrode 3 and an organic molecular dye which has a property for intramolecular CT (Charge Transfer) and which is held on the porous photoelectrode 3. In this case, the inorganic complex dye and the organic molecular dye are adsorbed on the porous photoelectrode 3 in different conformations. Preferably, the inorganic complex dye has a carboxyl group or phosphono group as a functional group for bonding to the porous photoelectrode 3. Besides, preferably, the organic molecular dye has a structure in which both a carboxyl group or phosphono group and a cyano group, amino group, thiol group or thione group are present on the same carbon atom, as the functional groups for bonding to the porous photoelectrode 3. The inorganic complex dye is, for example, a polypyridine complex; on the other hand, the organic molecular dye is, for example, an aromatic polycyclic conjugated molecule which has both an electron donating group and an electron accepting group and which has a property for intramolecular CT.

The method for adsorption of the photosensitizing dye onto the porous photoelectrode 3 is not specifically restricted. For example, a method may be used in which the photosensitizing dye is dissolved in a solvent such as alcohols, nitriles, nitromethane, halogenated hydrocarbons, ethers, dimethyl sulfoxide, amides, N-methylpyrrolidone, 1,3-dimethylimidazolidinone, 3-methyloxazolidinone, esters, carbonate esters, ketones, hydrocarbons, water, etc., and the porous photoelectrode 3 is immersed in the resulting solution. Alternatively, a solution containing the photosensitizing dye is applied onto the porous photoelectrode 3. Besides, deoxycholic acid or the like may be added to the solution for the purpose of suppressing association among the molecules of the photosensitizing dye. If necessary, a UV absorber may also be used together.

After the adsorption of the photosensitizing dye onto the porous photoelectrode 3, the surface of the porous photoelectrode 3 may be treated with an amine for the purpose of promoting removal of the excessive portion of the photosensitizing dye adsorbed. Examples of the amine in this case include pyridine, 4-tert-butylpyridine, and polyvinylpyridine. The amine may, when liquid, be used as it is, or may be used in the state of a solution in an organic solvent.

As the material of the counter electrode 6, any material that is electrically conductive can be used. There can also be used a material having a conductor layer formed on that side of an insulating material which faces the electrolyte layer 7. As the material of the counter electrode 6, a material which is electrochemically stable is used preferably. Specific examples of such a material include platinum, gold, carbon, and conductive polymer.

Besides, in order to enhance a catalytic action on a reduction reaction on the counter electrode 6, that surface of the counter electrode 6 which makes contact with the electrolyte layer 7 is preferably formed to have a microstructure such as to offer an increased actual surface area. For example, where the counter electrode 6 is formed of platinum, the surface of the counter electrode 6 is preferably formed in the state of platinum black. Where the counter electrode 6 is formed of carbon, the surface of the counter electrode 6 is preferably formed in the state of porous carbon. Platinum black can be formed by an anodizing method, a chloroplatinic acid treatment, or the like. On the other hand, the porous carbon can be formed by sintering of carbon particulates, burning of an organic polymer, or the like.

The counter electrode 6 is formed on the transparent conductor layer 5 formed on a principal surface of the counter substrate 4, but this configuration is not limitative. The material of the counter substrate 4 may be an opaque glass, plastic, ceramic or metal or the like, or may be a transparent material such as a transparent glass or plastic. To form the transparent conductor layer 5, there can be used materials identical or similar to the materials for the transparent electrode 2.

As the material for the sealing member, a material which has light resistance, insulating property, moisture-proof property and the like is preferably used. Specific examples of the material for the sealing member include epoxy resin, UV-curing resin, acrylic resin, polyisobutylene resin, EVA (ethylene-vinyl acetate copolymer), ionomer resin, ceramic, and various heat-weldable films.

In the case where an electrolyte solution is poured (or injected) for forming the electrolyte layer 7, a pouring port may be needed. The location of the pouring port is not specifically restricted, insofar as it is not on the porous photoelectrode 3 or on a portion, facing the porous photoelectrode 3, of the counter electrode 6. In addition, the method for pouring the electrolyte solution is not particularly limited. It is preferable, however, that the electrolyte solution is poured under a reduced pressure into the inside of the photoelectric conversion element the outer periphery of which is preliminarily sealed and which is provided with a solution pouring port. In this case, a method in which several drops

of the solution are dropped on the pouring port and the solution is poured into the inside of the photoelectric conversion element by capillarity is simple and easy to carry out. If necessary, pressure reduction and/or heating may be conducted in carrying out the solution pouring operation. After the electrolyte solution is poured in completely, the solution remaining on the pouring port is removed, and the pouring port is sealed off. The sealing method in this case, also, is not specifically restricted. If necessary, the sealing may be conducted by adhering a glass plate or plastic substrate with a sealing agent. Another sealing method may be adopted in which, like in the liquid crystal dropping pouring (ODF: One Drop Filling) step in the manufacture of a liquid crystal panel, the electrolyte solution is dropped onto a substrate, then the substrates are adhered to each other under a reduced pressure, and are sealed. After the sealing, heating and/or pressurization may be carried out, as required, for securing sufficient impregnation of the porous photoelectrode 3 with the electrolyte solution.

[Method of manufacturing dye-sensitized photoelectric conversion element]

Now, a method of manufacturing the dye-sensitized photoelectric conversion element as above will be described below.

First, a transparent conductor layer is formed on a principal surface of a transparent substrate 1 by sputtering or the like, to form a transparent electrode 2.

Next, a porous photoelectrode 3 is formed on the transparent electrode 2. The method for forming the porous photoelectrode 3 is not particularly limited. In consideration of physical properties, convenience, production cost and the like, however, it is preferable to use a wet film forming method. In the wet film forming method, preferably, a pasty dispersion is prepared by uniformly dispersing a powder or sol of semiconductor particulates in a solvent such as water, and the dispersion is applied or printed onto the transparent electrode 2 on the transparent substrate 1. The applying (coating) or printing method for the dispersion in this case is not specifically restricted, and known methods can be used. Specific examples of the applying (coating) method include dipping method, spraying method, wire bar method, spin coating method, roller coating method, blade coating method, and gravure coating method. On the other hand, specific examples of the printing method include relief printing method, offset printing method, gravure printing method, intaglio printing method, rubber plate printing method, and screen printing method.

In the case where anatase-type $TiO_2$ is used as the material of the semiconductor particulates, the anatase-type $TiO_2$ may be a commercially available one which is in the form of powder, sol, or slurry. Or, alternatively, anatase-type $TiO_2$ having a predetermined particle diameter may be formed by a known method, such as hydrolysis of a titanium oxide alkoxide. In the case of using the commercially available powder, it is preferable to obviate agglomeration (secondary aggregation) of the particles; therefore, it is preferable to pulverize the particles by use of a mortar, a ball mill or the like in preparing the pasty dispersion. In this instance, acetylacetone, hydrochloric acid, nitric acid, a surfactant, a chelate agent or the like may be added to the pasty dispersion, in order that the particles restrained from agglomeration will be prevented from being aggregated again. Besides, a polymer such as polyethylene oxide, polyvinyl alcohol, etc. or a thickener such as a cellulose-based thickener may be added to the pasty dispersion, for the purpose of increasing the viscosity of the pasty dispersion.

After the semiconductor particulates are applied or printed onto the transparent electrode 2, the porous photoelectrode 3 is preferably burned so as to ensure that the semiconductor particulates are electrically connected to one another, that the mechanical strength of the porous photoelectrode 3 is enhanced, and that the adhesion of the porous photoelectrode 3 to the transparent electrode 2 is improved. The range of the burning temperature is not particularly limited. If the burning temperature is too high, the electrical resistance of the transparent electrode 2 would be raised and, further, the transparent electrode 2 might be melted. Normally, therefore, the burning temperature is preferably in the range of 40 to 700°C, more preferably 40 to 650°C. Besides, while the burning time also is not specifically restricted, it is normally in the range from about 10 minutes to about 10 hours.

After the burning, dipping in an aqueous titanium tetrachloride solution or in a sol of titanium oxide ultrafine particulates of 10 nm or below in diameter may be conducted, for the purpose of increasing the surface area of the semiconductor particulates or enhancing the necking between the semiconductor particulates. In the case where a plastic substrate is used as the transparent substrate 1 for supporting the transparent electrode 2, a method may be adopted in which the porous photoelectrode 3 is formed on the transparent electrode 2 by use of a pasty dispersion containing a binder, and the porous photoelectrode 3 is adhered under pressure to the transparent electrode 2 by use of a hot press.

Next, the transparent substrate 1 provided with the porous photoelectrode 3 is immersed in a solution prepared by dissolving the photosensitizing dye(s) in a predetermined solvent, to bond the photosensitizing dye(s) to the porous photoelectrode 3.

On the other hand, a transparent conductor layer 5 and a counter electrode 6 are sequentially formed over a counter substrate 4 by sputtering or the like.

Next, the transparent substrate 1 and the counter substrate 4 are so arranged that the porous photoelectrode

3 and the counter electrode 6 face each other, with a gap of, for example, 1 to 100 μm, preferably, 1 to 50 μm, therebetween. Subsequently, a sealing member (not shown) is formed along the outer peripheral portions of the transparent substrate 1 and the counter substrate 4, to form a space in which to enclose an electrolyte layer 7, and an electrolyte solution is poured into the space through a solution pouring port (not shown) preliminarily formed, for example, in the transparent substrate 1, to form the electrolyte layer 7. Thereafter, the pouring port is sealed off.

By the process as above, the desired dye-sensitized photoelectric conversion element is manufactured.

[Operation of the dye-sensitized photoelectric conversion element]

Now, operation of the dye-sensitized photoelectric conversion element as above will be described below.

The dye-sensitized photoelectric conversion element, upon incidence of light thereon, operates as a cell in which the counter electrode 6 serves as a positive electrode and the transparent electrode 2 serves as a negative electrode. The principle of this operation is as follows. Here, it is assumed that FTO is used as the material for the transparent electrode 2, $TiO_2$ is used as the material for the porous photoelectrode 3, and $I^-/I_3^-$ oxidation-reduction species is used as the redox couple, but this is not limitative. In addition, it is assumed that one kind of photosensitizing dye is bonded to the porous photoelectrode 3.

When a photon transmitted through the transparent substrate 1 and the transparent electrode 2 and incident on the porous photoelectrode 3 is absorbed by the photosensitizing dye bonded to the porous photoelectrode 3, an electron(s) in the photosensitizing dye is excited from a ground state (HOMO) to an excited state (LUMO). The thus excited electron(s) is drawn out into the conduction band of the $TiO_2$ constituting the porous photoelectrode 3, through the electrical coupling between the photosensitizing dye and the porous photoelectrode 3, and passes through the porous photoelectrode 3 to reach the transparent electrode 2.

On the other hand, the photosensitizing dye having lost the electron(s) receives an electron(s) from the reducing agent, for example, $I^-$, in the electrolyte layer 7 through the following reaction, whereby an oxidizing agent, for example, $I_3^-$ (a coupled body of $I_2$ and $I^-$), is produced in the electrolyte layer 7.

$$2I^- \rightarrow I_2 + 2e^-$$

$$I_2 + I^- \rightarrow I_3^-$$

The oxidizing agent thus produced diffuses to reach the counter electrode 6, where it receives an electron(s) from the counter electrode 6 through the reverse reaction (reverse to the above-mentioned reaction), thereby being reduced to the original reducing agent.

$$I_3^- \rightarrow I_2 + I^-$$

$$I_2 + 2e^- \rightarrow 2I^-$$

The electron(s) sent out from the transparent electrode 2 into an external circuit acts for an electrical work in the external circuit, before returning to the counter electrode 6. In this manner, light energy is converted into electrical energy, without leaving any change in the photosensitizing dye or in the electrolyte layer 7.

Now, operation of a dye-sensitized photoelectric conversion element in which two kinds of photosensitizing dyes are bonded to a porous photoelectrode 3 will be described below. Here, as one non-limitative example, it is assumed that Z907 and Dye A are bonded to the porous photoelectrode 3. Dye A is 2-cyano-3-[4-[4-(2,2-diphenylethenyl)phenyl]-1,2,3,3a,4,8b-hexahydrocyclopent[b]indol-7-yl]-2-propenoic acid. FIG. 2 is an energy diagram for illustrating the principle of operation of this dye-sensitized photoelectric conversion element. The dye-sensitized photoelectric conversion element, upon incident of light thereon, operates as a cell in which a counter electrode 6 serves as a positive electrode and a transparent electrode 2 serves as a negative electrode. The principle of operation is as follows. Here, it is assumed that FTO is used as the material for the transparent electrode 2, $TiO_2$ is used as the material for the porous photoelectrode 3, and oxidation-reduction species of $I^-/I_3^-$ is used as a redox couple, but this is not limitative.

FIG. 3 shows the structural formula of Z907, and FIG. 4 shows the measurement results of IPCE (Incident Photon-to-current Conversion Efficiency) spectrum in the case where Z907 alone was adsorbed on the surface of the porous photoelectrode 3. In addition, FIG. 5 shows the structural formula of Dye A, and FIG. 6 shows the measurement results of IPCE spectrum in the case where Dye A alone was adsorbed on the surface of the porous photoelectrode 3. As shown in FIGS. 4 and 6, although Z907 can absorb light in a wide range of wavelength, its light absorbance is deficient in a certain short wavelength region, and, in this short wavelength region, Dye A having a high absorbance in the short wavelength region assists the light absorption. In other words, Dye A serves as a photosensitizing dye which has a high absorbance in a short wavelength region.

As shown in FIG. 3, Z907 has carboxyl groups (-COOH) as functional groups for strong bonding to the porous photoelectrode 3, and the carboxyl groups are bonded to the porous photoelectrode 3. On the other hand, as shown in FIG. 5, Dye A has a structure in which both a carboxyl group (-COOH) as a functional group for strong bonding to the porous photoelectrode 3 and a cyano group (-CN) as a functional group for weak bonding to the porous photoelectrode 3 are bonded to the same carbon atom. Besides, in Dye A, the carboxyl group and the cyano group which are bonded to the same carbon atom are bonded to the porous photoelectrode 3. Thus, Dye A is adsorbed on the porous photoelectrode 3 through the carboxyl group and the cyano group which are bonded to the same carbon atom, and, therefore, Dye A is adsorbed to the porous photoelectrode 3 in a conformation different from that of Z907 which is adsorbed on the porous photoelectrode 3 through only the carboxyl groups. Here, if all of the plurality of functional groups bonded to the same carbon atom in Dye A are functional groups for strong bonding to the porous photoelectrode 3, Dye A adsorbed on the porous photoelectrode 3 would be low in the degree of freedom of conformation, so that the effect of the presence of the plurality of functional groups bonded to the same carbon atom would be exhibited with difficulty. In Dye A, on the other hand, the cyano group weakly bonded to the porous photoelectrode 3 functions in an auxiliary manner, and, moreover, it would not hamper the bonding to the porous photoelectrode 3 of the carboxyl group which, per se, is capable of strong bonding to the porous photoelectrode 3. As a result, in Dye A, the effect of the bonding of both the carboxyl group and the cyano group to the same carbon atom is exhibited effectively. In other words, Dye A and Z907 can, even when adjacent to each other on the porous photoelectrode 3, coexist without any strong interaction therebetween and, therefore, would not spoil each other's photoelectric conversion performance. On the other hand, Dye A is effectively interposed between the Z907 molecules bonded to the same surface of the porous photoelectrode 3 as that to which it is bonded, thereby restraining association of the Z907 molecules and preventing useless electron transfer among the Z907 molecules. Therefore, from the Z907 molecules which have absorbed light, excited electrons are efficiently taken out to the porous photoelectrode 3, without undergoing useless transfer among the Z907 molecules. Accordingly, the photoelectric conversion efficiency of Z907 is enhanced. In addition, excited electrons in the Dye A molecules which have absorbed light are taken out to the porous photoelectrode 3 through the carboxyl groups which are strongly bonded to the porous photoelectrode 3, so that charge transfer to the porous photoelectrode 3 takes place efficiently.

When photons having been transmitted through the transparent substrate 1, the transparent electrode 2 and the porous photoelectrode 3 are absorbed by the photosensitizing dye bonded to the porous photoelectrode 3, namely, by Z907 and Dye A, electrons in both Z907 and Dye A are excited from a ground state (HOMO) to an excited state (LUMO). In this case, since the photosensitizing dye includes both Z907 and Dye A, light in a broader wavelength region can be absorbed in a higher light absorptivity, as compared with the case of a dye-sensitized photoelectric conversion element in which the photosensitizing dye is composed of a single dye.

The electrons in the excited state are drawn out into the conduction band of the porous photoelectrode, 3 through the electrical coupling between the photosensitizing dye (namely, Z907 and Dye A) and the porous photoelectrode 3, and then pass through the porous photoelectrode 3 to reach the transparent electrode 2. In this case, Z907 and Dye A are sufficiently different from each other in minimum excitation energy, in other words, HOMO-LUMO gap. Moreover, Z907 and Dye A are bonded to the porous photoelectrode 3 in different conformations. Therefore, useless electron transfer between Z907 and Dye A is unlikely to occur. Accordingly, Z907 and Dye A would not lower each other's quantum yield, so that the photoelectric conversion functions of both Z907 and Dye A are exhibited satisfactorily, and the quantity of current generated is considerably enhanced. Besides, in this system, there are two kinds of routes through which the electrons in the excited state in Dye A are drawn out into the conduction band of the porous photoelectrode 3. One is a direct route $P_1$, namely, direct transfer of electrons from the excited state in Dye A into the conduction band of the porous photoelectrode 3. The other is an indirect route $P_2$, which is composed of a first transfer of electrons from the excited state in Dye A to the excited state in Z907 (with a lowering in energy level) and a second transfer of electrons from the excited state in Z907 into the conduction band of the porous photoelectrode 3. The indirect route $P_2$contributes to an enhanced photoelectric conversion efficiency of Dye A in the system in which Z907 is present in addition to Dye A.

On the other hand, the Z907 and Dye A molecules which have lost electrons receive electrons from a reducing agent, for example, $I^-$, in the electrolyte layer 7 through the following reaction, to produce an oxidizing agent, for example, $I_3^-$ (a coupled body of $I_2$ and $I^-$), in the electrolyte layer 7.

$$2I^- \rightarrow I_2 + 2e^-$$

$$I_2 + I^- \rightarrow I_3^-$$

The oxidizing agent thus produced diffuses to reach the counter electrode 6, where it accepts an electron(s) from the counter electrode 6 through the reverse reaction (reverse to the above-mentioned reaction), to be reduced to the original reducing agent.

$$I_3^- \rightarrow I_2 + I^-$$

$$I_2 + 2e^- \rightarrow 2I^-$$

Electrons sent out from the transparent electrode 2 to an external circuit acts for an electrical work in the external circuit, before returning to the counter electrode 6. In this manner, light energy is converted into electrical energy, without leaving any change in the photosensitizing dyes (namely, Z907 and Dye A) or in the electrolyte layer 7.

<Example 1>

A dye-sensitized photoelectric conversion element was manufactured as follows.
A pasty dispersion of $TiO_2$ as a raw material for forming a porous photoelectride 3 was prepared by reference to "The Latest Technologies of Dye-Sensitized Solar Cells" (supervised by Hironori Arakawa, 2001, CMC Publishing Co., Ltd.). Specifically, first, 125 mL of titanium isopropoxide was gradually dropped into 750 mL of 1 M aqueous nitric acid solution with stirring at room temperature. After the dropping, the resulting mixture was transferred into a thermostat set at 80°C, and stirring was continued for 8 hours, to obtain a cloudy semitransparent sol solution. The sol solution was left cool to room temperature, and was filtered through a glass filter, followed by addition of solvent until the volume of the solution became 700 mL. The sol solution thus obtained was transferred into an autoclave, was subjected to a hydrothermal reaction at 220°C for 12 hours, and was subjected to a dispersing treatment by ultrasonication for 1 hour. Next, the solution thus obtained was concentrated by use of an evaporator at 40°C so as to adjust the $TiO_2$ content to 20 wt%. To the thus concentrated sol solution, polyethylene glycol (molecular weight: 500,000) in an amount of 20% (based on the weight of $TiO_2$) and anatase-type $TiO_2$ of a particle diameter of 200 nm in an amount of 30% (based on the weight of $TiO_2$) were added, and the resulting admixture was uniformly mixed by a stirring and degassing apparatus, to obtain a pasty $TiO_2$ dispersion increased in viscosity.
The pasty dispersion of $TiO_2$ was applied onto an FTO layer serving as a transparent electrode 2 by a blade coating method, to form a particulate layer measuring 5 mm x 5 mm and 200 $\mu$m in thickness. Thereafter, the assembly was held at 500°C for 30 minutes, to sinter the $TiO_2$ particulates on the FTO layer. Onto the $TiO_2$ film thus sintered, 0.1 M aqueous solution of titanium(IV) chloride $TiCl_4$ was dropped, followed by holding at room temperature for 15 hours, washing, and again sintering at 500°C for 30 minutes. Thereafter, the $TiO_2$ sintered body was irradiated with UV rays for 30 minutes by use of a UV irradiation apparatus, whereby impurities such as organic matter contained in the $TiO_2$ sintered body were removed through oxidative decomposition under a photocatalytic action of $TiO_2$ and the activity of the $TiO_2$ sintered body was enhanced, to obtain a porous photoelectrode 3.
As a photosensitizing dye, 23.8 mg of Z907 purified sufficiently was dissolved in 50 mL of a 1:1 (by volume) mixed solvent of acetonitrile and tert-butanol, to prepare a photosensitizing dye solution.
Incidentally, in the case of using Z907 and Dye A as the photosensitizing dyes, 23.8 mg of Z907 and 2.5 mg of Dye A both purified sufficiently are dissolved in 50 mL of a 1:1 (by volume) mixed solvent of acetonitrile and tert-butanol, to prepare a photosensitizing dye solution.
Next, the porous photoelectrode 3 was immersed in the photosensitizing dye solution at room temperature for 24 hours, to hold the photosensitizing dye on the surfaces of the $TiO_2$ particulates. Subsequently, the porous photoelectrode 3 was washed sequentially with an acetonitrile solution of 4-tert-butylpyridine and with acetonitrile, and then dried by evaporating the solvent in a dark place.
A counter electrode 6 was formed as follows. On an FTO layer preliminarily provided with a pouring port of 0.5

mm in diameter, a 50 nm-thick chromium layer and a 100 nm-thick platinum layer were sequentially formed by sputtering, and an isopropyl alcohol (2-propanol) solution of chloroplatinic acid was applied thereto by spray coating, followed by heating at 385°C for 15 minutes.

Next, the transparent substrate 1 and the counter substrate 4 were so arranged as to let the porous photoelectrode 3 and the counter electrode 6 face each other, and the outer periphery of the assembly was sealed by use of a 30 μm-thick ionomer resin film and an acrylic UV-curing resin.

On the other hand, 1.0 g of 1-prapyl-3-methylimidazolium iodide, 0.10 g of iodine, and 0.054 g of N-butylbenzimidazole (NBB) were dissolved in 2.0 g of a 1:1 (by weight) mixed solvent of EMImTCB and diglyme, to prepare an electrolyte solution.

Incidentally, in the case of using Z907 and Dye A as the photosensitizing dyes, for example, 0.030 g of sodium iodide (NaI), 1.0 g of 1-propyl-2,3-dimethylimidazolium iodide, and 0.054 g of 4-tert-butylpyridine (TBP) are dissolved in 2.0 g of a 1:1 (by weight) mixed solvent of EMImTCB and diglyme, to prepare an electrolyte solution.

The electrolyte solution was poured into the photoelectric conversion element through the pouring port preliminarily formed in the photoelectric conversion element by use of a liquid feeding pump, followed by pressure reduction to expel bubbles from the inside of the element. In this manner, an electrolyte layer 7 was formed. Subsequently, the pouring port was sealed off by use of an ionomer resin film, an acrylic resin and a glass substrate, to complete a dye-sensitized photoelectric conversion element.

<Example 2>

A dye-sensitized photoelectric conversion element was manufactured in the same manner as in Example 1, except that an electrolyte solution was prepared by using a 1:1 (by weight) mixed solvent of EMImTCB and triglyme as solvent.

<Example 3>

A dye-sensitized photoelectric conversion element was manufactured in the same manner as in Example 1, except that an electrolyte solution was prepared by using a 1:1. (by weight) mixed solvent of EMImTCB and tetraglyme as solvent.

<Example 4>

A dye-sensitized photoelectric conversion element was manufactured in the same manner as in Example 1., except that an electrolyte solution was prepared by using a 1:1 (by weight) mixed solvent of EMImTCB and MPN as solvent.

<Example 5>

A dye-sensitized photoelectric conversion element was manufactured in the same manner as in Example 1, except that an electrolyte solution was prepared by using a 1:1 (by weight) mixed solvent of EMImTCB and PhOAN as solvent.

<Example 6>

A dye-sensitized photoelectric conversion element was manufactured in the same manner as in Example 1, except that an electrolyte solution was prepared by using a 1:1 (by weight) mixed solvent of EMImTCB and GBL as solvent.

<Example 7>

A dye-sensitized photoelectric conversion element was manufactured in the same manner as in Example 1, except that an electrolyte solution was prepared by using a 1:1 (by weight) mixed solvent of EMImTCB and PC as solvent.

<Example 8>

A dye-sensitized photoelectric conversion element was manufactured in the same manner as in Example 1, except that an electrolyte solution was prepared by using a 1:1 (by weight) mixed solvent of EMImTCB and aniline as solvent.

<Example 9>

A dye-sensitized photoelectric conversion element was manufactured in the same manner as in Example 1, except that an electrolyte solution was prepared by using a 1:1 (by weight) mixed solvent of EMImTCB and DMF as solvent.

<Example 10>

A dye-sensitized photoelectric conversion element was manufactured in the same manner as in Example 1, except that an electrolyte solution was prepared by using a 1:1 (by weight) mixed solvent of EMImTCB and DManiline as solvent.

<Example 11>

A dye-sensitized photoelectric conversion element was manufactured in the same manner as in Example 1, except that an electrolyte solution was prepared by using a 1:1 (by weight) mixed solvent of EMImTCB and NBB as solvent.

<Example 12>

A dye-sensitized photoelectric conversion element was manufactured in the same manner as in Example 1, except that an electrolyte solution was prepared by using a 1:1 (by weight) mixed solvent of EMImTCB and TBP as solvent.

<Example 13>

A dye-sensitized photoelectric conversion element was manufactured in the same manner as in Example 1, except that an electrolyte solution was prepared by using a 1:1 (by weight) mixed solvent of EMImTFSI and triglyme as solvent.

<Example 14>

A dye-sensitized photoelectric conversion element was manufactured in the same manner as in Example 1, except that an electrolyte solution was prepared by using a 1:1 (by weight) mixed solvent of EMImFAP and triglyme as solvent.

<Example 15>

A dye-sensitized photoelectric conversion element was manufactured in the same manner as in Example 1, except for the following.

Z991 was used as the photosensitizing dye to be bonded to the porous photoelectrode 3. FIG. 7 shows the structural formula of Z991. As shown in FIG. 7, Z991 has a carboxyl group (-COOH) as a functional group for strong bonding to the porous photoelectrode 3, and the carboxyl group is bonded to the porous photoelectrode 3.

Besides, an electrolyte solution was prepared by putting 1.0 g of 1-propyl-3-methylimidazolium iodide, 0.10 g of iodine ($I_2$), and 0.054 g of N-butylbenzoimidazole (NBB) into 2.0 g of a 1:1 (by weight) mixed solvent of EMImTCB and EMS used as solvent.

<Example 16>

A dye-sensitized photoelectric conversion element was manufactured in the same manner as in Example 1, except that:

Z991 was used as the photosensitizing dye to be bonded to the porous photoelectrode 3; and
an electrolyte solution was prepared by putting 1.0 g of 1-propyl-3-methylimidazolium iodide, 0.10 g of iodine ($I_2$), and 0.045 g of N-butylbenzoimidazole (NBB) into 2.0 g of a 1:1 (by weight) mixed solvent of EMImTCB and DMSO used as solvent.

<Example 17>

A dye-sensitized photoelectric conversion element was manufactured in the same manner as in Example 1, except that:

Z991 was used as the photosensitizing dye to be bonded to the porous photoelectrode 3;
an electrolyte solution was prepared by putting 1.0 g of 1-propyl-3-methylimidazolium iodide, 0.10 g of iodine ($I_2$), and 0.045 g of N-butylbenzoimidazole (NBB) into 2.0 g of a 1:1 (by weight) mixed solvent of EMImTCB and EMS used as solvent; and
the thus prepared electrolyte solution and silica particulates were sufficiently mixed in a weight ratio of 9:1, to gel the electrolyte solution.

<Comparative Example 1>

A dye-sensitized photoelectric conversion element was manufactured in the same manner as in Example 1, except that an electrolyte solution was prepared by using diglyme as solvent.

<Comparative Example 2>

A dye-sensitized photoelectric conversion element was manufactured in the same manner as in Example 1, except that an electrolyte solution was prepared by using EMImTCB as solvent.

<Comparative Example 3>

A dye-sensitized photoelectric conversion element was manufactured in the same manner as in Example 1, except that an electrolyte solution was prepared by using MPN as solvent.

<Comparative Example 4>

A dye-sensitized photoelectric conversion element was manufactured in the same manner as in Example 1, except that an electrolyte solution was prepared by using a 1:1 (by weight) mixed solvent of EMImTCB and PhAN (phenyl acetonitrile) as solvent.

<Comparative Example 5>

A dye-sensitized photoelectric conversion element was manufactured in the same manner as in Example 1, except that an electrolyte solution was prepared by using a 1:1 (by weight) mixed solvent of $EMImBF_4$ (1-ethyl-3-methylimidazolium tetrafluoroborate) and triglyme as solvent.

<Comparative Example 6>

A dye-sensitized photoelectric conversion element was manufactured in the same manner as in Example 1, except that an electrolyte solution was prepared by using a 1:1 (by weight) mixed solvent of EMImOTf (1-ethyl-3-methylimidazolium trifluromethanesulfonate) and triglyme as solvent.

<Comparative Example 7>

A dye-sensitized photoelectric conversion element was manufactured in the same manner as in Example 1, except that an electrolyte solution was prepared by using a 1:1 (by weight) mixed solvent of $P_{222}$MOMTFSI (triethyl (methoxymethyl)phosphonium bis(trifluoromethylsulfonyl)imide) and triglyme as solvent.

<Comparative Example 8>

A dye-sensitized photoelectric conversion element was manufactured in the same manner as in Example 1, except that an electrolyte solution was prepared by using a 1:1 (by weight) mixed solvent of $EMImBF_4$ and triglyme as solvent.

<Comparative Example 9>

A dye-sensitized photoelectric conversion element was manufactured in the same manner as in Example 1, except that:

Z991 was used as the photosensitizing dye to be bonded to the porous photoelectrode 3; and

an electrolyte solution was prepared by using EMImTCB as solvent.

Table 1 shows the results of determination of evaporation rate lowering ratio $Z_{vapor}$ for the mixed solvent of the ionic liquid and the organic solvent in each of Examples 1 to 17 and Comparative Examples 4 to 7. The content of the organic solvent in the mixed solvent was 50 wt%. The evaporation rate lowering ratio $Z_{vapor}$ is defined as $Z_{vapor}$ (%) = [1-(content, by weight, of organic solvent in mixed solvent)$\times$($k_{mixture}$/$k_{neat}$)]x100, where $k_{neat}$ is the evaporation rate of the organic solvent alone, and mixture is the evaporation rate of the mixed solvent of the ionic liquid and the organic solvent, both of which are determined by TG (Thermo Gravity)-DTA (Differential Thermal Analysis) measurement. A higher value of $Z_{vapor}$ indicates a larger lowering in the volatility of the organic solvent component in the mixed solvent, as compared with the case of using the organic solvent alone. For several embodiments, in an electrolyte solution having an organic solvent mixed with an ionic liquid, increasing the amount of ionic liquid in the electrolyte solution generally reduces the volatility of the electrolyte solution. Therefore, decreasing the amount of ionic liquid in the electrolyte solution results in an increase in volatility. Accordingly, the volatility of an electrolyte solution having a mixture of ionic liquid and organic solvent will be lower than the volatility of an electrolyte solution of just the organic solvent in the absence of ionic liquid.

[Table 1]

| | Ionic liquid | Organic solvent | $Z_{vapor}$ |
|---|---|---|---|
| Example 1 | EMImTCB | diglyme | 50 |
| Example 2 | EMImTCB | triglyme | 59 |
| Example 3 | EMImTCB | tetraglyme | 78 |
| Example 4 | EMImTCB | MPN | 12 |
| Example 5 | EMImTCB | PhOAN | 11 |
| Example 6 | EMImTCB | GBL | 14 |
| Example 7 | EMImTCB | PC | 9 |
| Example 8 | EMImTCB | aniline | 31 |
| Example 9 | EMImTCB | DMF | 39 |
| Example 10 | EMImTCB | DManiline | 8 |
| Example 11 | EMImTCB | NBB | 6 |
| Example 12 | EMImTCB | TBP | 7 |
| Example 13 | EMImTFSI | triglyme | 37 |
| Example 14 | EMImFAP | triglyme | 25 |
| Example 15 | EMImTCB | EMS | 26 |
| Example 16 | EMImTCB | DMSO | 27.5 |
| Example 17 | EMImTCB | EMS | 26 |
| Comp.Ex. 4 | EMImTCB | PhAN | 0 |
| Comp.Ex. 5 | $EMImBF_4$ | triglyme | -12 |
| Comp.Ex. 6 | EMImOTf | triglyme | -2 |
| Comp.Ex. 7 | $P_{222}$MOMTFSI | triglyme | -9 |

From Table 1 it is seen that in Examples 1 to 17, $Z_{vapor}$ has a large positive value, indicating a lowering in the volatility of the organic solvent component owing to mixing of the ionic liquid with the organic solvent. On the other hand, in Comparative Examples 4 to 7, $Z_{vapor}$ has a value of 0 or a negative value, indicating no lowering in the volatility of the organic solvent component owing to mixing of the ionic liquid with the organic solvent.

FIG. 8 shows TG-DTA curves for various solvents. As seen from FIG. 8, in the case where a mixed solvent of EMImTCB and MPN (EMImTCB content: 50 wt%) is used (Example 4, curve (4)), weight loss of the solvent is much smaller than that in the case of using MPN alone (Comparative Example 3, curve (5)). Besides, in the case where a mixed solvent of EMImTCB and GBL (EMImTCB content: 50 wt%) is used (Example 6, curve (2)), weight loss of the solvent is much smaller than that in the case of using GBL alone (curve (3)).

FIG. 9 shows TG-DTA curves in the case where a mixed solvent of EMImTCB and diglyme (EMImTCB content: 50 wt%) is used (Example 4), in the case where EMImTCB is used alone, and in the case where diglyme is used alone. From FIG. 9 it is seen that in the case where the mixed solvent of EMImTCB and diglyme is used, weight loss of the solvent is extremely small as compared with the case of using diglyme alone, and the weight loss is suppressed to a level near that in the case of using EMImTCB alone.

FIG. 10 shows TG-DTA curves in the case where a mixed solvent of EMImTCB and triglyme (EMImTCB content: 50 wt%) is used (Example 2), in the case of using EMImTCB alone, and in the case of using triglyme alone. As seen from FIG 10, in the case where the mixed solvent of EMImTCB and triglyme is used, weight loss of the solvent is extremely small as compared with the case of using triglyme alone, and the weight loss is suppressed to a level near that in the case of using EMImTCB alone.

FIG. 11 shows TG-DTA curves in the case where a mixed solvent of EMImTCB and tetraglyme (EMImTCB content: 50 wt%) is used (Example 3), in the case of using EMImTCB alone, and in the case of using tetraglyme alone. It is seen from FIG. 11 that in the case where the mixed solvent of EMImTCB and tetraglyme is used, weight loss of the solvent is extremely small as compared with the case of using tetraglyme alone, and the weight loss is almost zero, like in the case of using EMImTCB alone.

Dye-sensitized photoelectric conversion elements manufactured by using an EMImTCB-diglyme mixed solvent, EMImTCB alone and diglyme alone, respectively, as the solvent of the electrolyte solution were served to measurement of current-voltage characteristic. The measurement was conducted by irradiating the dye-sensitized photoelectric conversion element with pseudo-sunlight (AM 1.5, 100 mW/cm$^2$). Table 2 shows open circuit voltage $V_{oc}$, current density $J_{sc}$, fill factor (FF) and photoelectric conversion efficiency, measured for these dye-sensitized photoelectric conversion elements.

[Table 2]

| Solvent | $V_{oc}$ [v] | $J_{sc}$ [mA/cm$^2$] | FF [%] | Photoelectric conversion efficiency [%] |
|---|---|---|---|---|
| EMImTCB | 0.737 | 12.60 | 67.1 | 6.23 |
| 50wt%EMImTCB/diglyme | 0.732 | 13.92 | 67.1 | 6.83 |
| diglyme | 0.739 | 13.85 | 68.0 | 6.96 |

As seen from Table 2, the dye-sensitized photoelectric conversion element manufactured in Example 1 by use of the EMImTCB-diglyme mixed solvent as the solvent of the electrolyte solution is much better in photoelectric conversion characteristic than the dye-sensitized photoelectric conversion element manufactured in Comparative Example 2 by use of EMImTCB alone as the solvent of the electrolyte solution. The photoelectric conversion characteristic achieved by use of the mixed solvent in Example 1 is comparable to that in the case of using diglyme alone as the solvent of the electrolyte solution.

Dye-sensitized photoelectric conversion elements manufactured by using a mixed solvent of EMImTCB and MPN (EMImTCB content: 22 wt%), a mixed solvent of EMImTFSI and MPN (EMImTFSI content: 35 wt%), and MPN alone, respectively, as the solvent of the electrolyte solution were served to measurement of current-voltage curve. The measurement was carried out by irradiating the dye-sensitized photoelectric conversion element with pseueo-sunlight (AM 1.5, 100 mW/cm$^2$). Table 3 shows open circuit voltage $V_{oc}$, current density $J_{sc}$, fill factor (FF) and photoelectric conversion efficiency, measured for these dye-sensitized photoelectric conversion elements.

[Table 3]

| Solvent | $V_{oc}$ [v] | $J_{sc}$ [mA/cm$^2$] | FF [%] | Photoelectric conversion efficiency [%] |
|---|---|---|---|---|
| MPN | 0.71 | 15.7 | 63 | 7.0 |
| 22wt%EMImTCB/MPN | 0.73 | 14.8 | 65 | 7.0 |
| 35wt%EMImTFSI/MPN | 0.72 | 14.9 | 65 | 7.0 |

As seen from Table 3, both the dye-sensitized photoelectric conversion element using the EMImTCB-MPN mixed solvent as the solvent of the electrolyte solution and the dye-sensitized photoelectric conversion element using the EMImTFSI-MPN mixed solvent as the solvent of the electrolyte solution showed photoelectric conversion characteristics comparable to that of the dye-sensitized photoelectric conversion element using MPN alone as the solvent of the electrolyte solution. Here, it is seen that in the dye-sensitized photoelectric conversion elements respectively using the above-mentioned mixed solvents as the solvent of the electrolyte solution, $J_{sc}$ is lowered and $V_{oc}$ is raised, as compared with those in the dye-sensitized photoelectric conversion element using MPN alone as the solvent of the electrolyte solution. The lowering in $J_{sc}$ is considered to be attributable to a lowering in diffusivity of the redox couple in the electrolyte solution which arises from the mixing of the ionic liquid. Besides, the rise in Voc is considered to be attributable to a change in the electron potential in titanium oxide due to pseudo-adsorption of the ionic liquid on the surface of the porous photoelectrode composed of titanium oxide, or attributable to a change in the oxidation-reduction

potential arising from an interaction of the ionic liquid with the redox couple.

The dye-sensitized photoelectric conversion element fabricated in Table 15 by using the EMImTCB-EMS mixed solvent (EMImTCB content: 50 wt%) as the solvent of the electrolyte solution was served to measurement of current-voltage curve. In addition, the dye-sensitized photoelectric conversion element obtained in Comparative Example 9 by use of EMImTCB alone as the solvent of the electrolyte solution was also served to measurement of current-voltage curve. The measurement was carried out by irradiating the dye-sensitized photoelectric conversion element with pseudo-sunlight (AM 1.5, 100 $mW/cm^2$). Table 4 shows open circuit voltage $V_{oc}$, current density $J_{sc}$, fill factor (FF) and photoelectric conversion efficiency, measured for these dye-sensitized photoelectric conversion elements.

[Table 4]

| Solvent | $V_{oc}$ [v] | $J_{sc}$ [$mA/cm^2$] | FF [%] | Photoelectric conversion efficiency [%] |
|---|---|---|---|---|
| EMImTCB | 0.667 | 11.94 | 72.6 | 5.78 |
| 50wt%EMImTCB/EMS | 0.666 | 14.09 | 71.8 | 6.73 |

As seen from Table 4, the dye-sensitized photoelectric conversion element manufactured in Example 15 by using the EMImTCB-EMS mixed solvent as the solvent of the electrolyte solution is higher in photoelectric conversion efficiency by about 1% and higher in $J_{sc}$ by no less than about 2 $mA/cm^2$, as compared with the dye-sensitized photoelectric conversion element obtained in Comparative Example 9 by using EMS alone as the solvent of the electrolyte solution. The increase in $J_{sc}$ is attributable to a lowering in the viscosity coefficient of the electrolyte solution.

Current-voltage curve was measured for the dye-sensitized photoelectric conversion element manufactured in Example 17 by a method in which an electrolyte solution prepared using an EMImTCB-EMS mixed solvent (EMImTCB content: 50 wt%) as the solvent of the solution was sufficiently mixed with silica particulates in a weight ratio of 9:1 to gel the electrolyte solution, and the thus gelled electrolyte solution is used. The measurement was conducted by irradiating the dye-sensitized photoelectric conversion element with pseudo-sunlight (AM 1.5, 100 $mW/cm^2$). Table 5 shows open circuit voltage $V_{oc}$, current density $J_{sc}$, fill factor (FF) and photoelectric conversion efficiency, measured for this dye-sensitized photoelectric conversion element. For comparison, Table 5 also shows open circuit voltage $V_{oc}$, current density $J_{sc}$, fill factor (FF) and photoelectric conversion element, measured for the dye-sensitized photoelectric conversion element fabricated in Example 15 by use of the EMImTCB-EMS mixed solvent as the solvent of the electrolyte solution.

[Table 5]

| Solvent | $V_{oc}$ [v] | $J_{sc}$ [$mA/cm^2$] | FF [%] | Photoelectric conversion efficiency [%] |
|---|---|---|---|---|
| 50wt%EMImTCB/EMS | 0.666 | 14.09 | 71.8 | 6.73 |
| 50wt%EMImTCB/EMS (electrolyte solution, gelled) | 0.685 | 13.72 | 69.9 | 6.57 |

As seen from Table 5, the dye-sensitized photoelectric conversion element manufactured in Example 17 by using the gelled electrolyte solution has photoelectric conversion characteristics comparable to those of the dye-sensitized photoelectric conversion element obtained in Example 15 by use of the EMImTCB-EMS mixed solvent as the solvent of the electrolyte solution.

FIG. 12 shows the results of an acceleration test for dye-sensitized photoelectric conversion elements using an EMImTCB-MPN mixed solvent (EMImTCB content: 22 wt%), an EMImTFSI-MPN mixed solvent (EMImTFSI content: 35 wt%), and MPN alone, respectively, as the solvent of the electrolyte solution. In F1G 12, the axis of abscissas indicates holding time at 85°C, and the axis of ordinates indicates photoelectric conversion efficiency. The test was carried out by holding the dye-sensitized photoelectric conversion element at 85°C in a dark place.

As seen from F1G 12, in the dye-sensitized photoelectric conversion element using MPN alone as the solvent of the electrolyte solution, the photoelectric conversion efficiency continued decreasing after the start of the test, and the value of photoelectric conversion efficiency after 170 hr was lower than the initial value by no less than 30%, On the other hand, in each of the dye-sensitized photoelectric conversion elements using the EMImTCB-MPN mixed solvent (EMImTCB content: 22 wt%) and the EMImTFSI-MPN mixed solvent (EMImTFSI content: 35 wt%), respectively, as the solvent of the electrolyte solution, the lowering in photoelectric conversion efficiency was little even after the lapse of 170 hr, which indicates high durability of these dye-sensitized photoelectric conversion elements. This is considered to be attributable to a lowering in volatility owing to interaction of the ionic liquid molecules with the organic solvent molecules, and/or attributable to stabilization owing to interaction of the ionic liquid molecules with the electrolyte solution component-electrode interfaces.

FIG. 13 shows the results of examination of the relationship between the content of EMImTCB, in the EMImTCB-diglyme mixed solvent used as the solvent of the electrolyte solution, and evaporation rate lowering ratio. As seen from FIG. 13, a lowering in evaporation rate is observed when the content of EMImTCB is not less than 15 wt%.

Now, preferable cation and anion structures in the ionic liquid will be described below. First, the cation is preferably an organic cation which has an aromatic amine cation having a quaternary nitrogen atom and has a hydrogen atom in an aromatic ring. Examples of such an organic cation include imidazolium cation, pyridinium cation, thiazolium cation, and pyrazonium cation. The anion can be specified by the van der Waals volume (the size of electron cloud) of the anion calculated on a computational science basis. FIG. 14 is a diagram showing evaporation rate lowering ratio plotted against van der Waals volume, for some anions ($TCB^-$, $TFSI^-$, OTf, $BF_4^-$). The values of van der Waals volume for the anions were obtained by reference to Journal of The Electrochemical Society 002, 149 (10), A1385-A1388 (2002). As the van der Waals volume of TCB anion, the van der Waals volume of $(C_2H_5)_4B^-$ anion, which is similar to the TCB anion in structure, was used. These data were subjected to fitting to a linear function. The fitting equation obtained is $y = 0.5898x - 44.675$, where x is van der Waals volume, and y is evaporation rate lowering ratio. It is considered from FIG 14 that a lowering in evaporation rate occurs in the cases of anions having a van der Waals volume of not less than 76 $Å^3$, preferably not less than 140 $Å^3$.

Now, description will be made of the results of consideration of the principle by which the evaporation rate is lowered in a mixed solvent containing an ionic liquid having an electron pair accepting functional group and an organic solvent having an electron pair donating functional group.

In the mixed solvent, a hydrogen bond is formed between the electron pair accepting functional group possessed by the ionic liquid and the electron pair donating functional group (ether group, amino group or the like) possessed by the organic solvent, resulting in thermal stability. FIG. 15 illustrates one example of this hydrogen bond formation. As shown in FIG. 15, in this example, a hydrogen bond (indicated by a broken line) is formed between the electron pair accepting functional group (acidic proton) of the imidazolium cation constituting the ionic liquid and the ether group (-O-) of the diglyme molecule. Thus, in this mixed solvent, the lowering in evaporation rate is considered to be attributable to thermal stabilization owing to the formation of hydrogen bonds between the ionic liquid and the organic solvent.

Especially, as the number of the electron pair donating functional groups present in one molecule of the organic solvent increases, the evaporation rate lowering ratio increases. For example, when the organic solvent is triglyme as shown in FIG 16, hydrogen bonds are formed respectively between the two electron pair accepting functional groups (acidic protons) of the imidazolium cation constituting the ionic liquid and the two ether groups of triglyme, whereby thermal stabilization is attained. Besides, in this case, when the hydrogen bond is formed between one electron pair accepting functional group of the imidazolium cation in the ionic liquid and one ether group of triglyme, another ether group of triglyme comes close to the other electron pair accepting functional group of the imidazolium cation in the ionic liquid. In other words, triglyme enfolds the imidazolium cation. Therefore, the other electron pair accepting functional group of the imidazolium cation in the ionic liquid and another ether group of triglyme are permitted to interact with each other more easily, so that the hydrogen bond is easily formed therebetween.

Thus, according to the first embodiment of the present invention, the mixed solvent which contains both the ionic liquid having the electron pair accepting functional group(s) and the organic solvent having the electron pair donating functional group(s) is used as the solvent of the electrolyte solution constituting the electrolyte layer 7. Therefore, volatilization (evaporation) of the electrolyte solution can be restrained. Moreover, the mixed solvent has a low viscosity coefficient, so that the viscosity coefficient of the electrolyte solution can be lowered. Consequently, it is possible to obtain a dye-sensitized photoelectric conversion element which has excellent photoelectric conversion characteristics.

<2. Second Embodiment>

[Dye-sensitized photoelectric conversion element]

FIG. 17 is an essential part sectional view showing a dye-sensitized photoelectric conversion element according to a second embodiment of the present invention.

As shown in FIG. 17, in the dye-sensitized photoelectric conversion element, a transparent electrode 12 is provided on a principal surface of a transparent substrate 11, and a porous photoelectrode 13 with one or a plurality of photosensitizing dyes bonded thereto (or adsorbed thereon) is provided on the transparent electrode 12. On the other hand, a counter electrode 14 is provided so as to face the transparent substrate 11. Besides, outer peripheral portions of the transparent substrate 11 and the counter electrode 14 are sealed off with a sealing member 15, and an electrolyte layer 16 is fillingly disposed between the porous photoelectrode 13 on the transparent substrate 11 and the counter electrode 14.

The porous photoelectrode 13 has metal-metal oxide particulates 17, and, typically, is composed of a sintered body of the metal-metal oxide particulates 17. Detailed structure of each of the metal-metal oxide particulates 17 is

illustrated in FIG. 18. As shown in F1G 18, the metal-metal oxide particulate 17 has a core-shell structure which includes a spherical core 17a having a metal and a shell 17b having a metal oxide surrounding the periphery of the core 17a. One or a plurality of photosensitizing dyes 18 are bonded to (or adsorbed on) the surface of the shell 17b having the metal oxide of the metal-metal oxide particulate 17.

Examples of the metal oxide constituting the shell 17b of each of the metal-metal oxide particulates 17 include titanium oxide ($TiO_2$), tin oxide ($SnO_2$), niobium oxide ($Nb_2O_3$), and zinc oxide (ZnO). Among these metal oxides, preferred is $TriO_2$, particularly, anatase-type $TiO_2$. It is to be noted here, however, that the metal oxide is not limited to these ones, and, if necessary, two or more metal oxides can be used in a mixed state or as a composite oxide. Besides, the shape of the metal-metal oxide particulates 17 may be any of granular shape, tubular shape, spherical shape, rod-like shape and the like.

The particle diameter of the metal-metal oxide particulates 17 is not particularly limited. In general, the particle diameter in terms of average particle diameter of primary particles is 1 to 500 nm, preferably 1 to 200 nm, and more preferably 5 to 100 nm. In addition, the particle diameter of the cores 17a of the metal-metal oxide particulates 17 is generally 1 to 200 nm.

As the transparent substrate 11, the transparent electrode 12, the counter electrode 14 and the electrolyte layer 16, there can be used respective ones identical or similar to the transparent substrate 1, the transparent electrode 2, the counter electrode 6 and the electrolyte layer 7 of the dye-sensitized photoelectric conversion element according to the first embodiment.

[Method of producing dye-sensitized photoelectric conversion element]

Now, a method of manufacturing this dye-sensitized photoelectric conversion element will be described below.

First, a transparent electrode 12 is formed on a primary surface of a transparent substrate 11 by sputtering or the like.

Next, a porous photoelectrode 13 having metal-metal oxide particulates 17 is formed on the transparent electrode 12.

In forming the porous photoelectrode 13, the metal-metal particulates 17 applied to or printed on the transparent electrode 12 are preferably sintered, for the purpose of electrically connecting the metal-metal oxide particulates 17 to one another, enhancing the mechanical strength of the porous photoelectrode 13, and improving the adhesion of the porous photoelectrode 13 to the transparent electrode 12.

Next, the transparent substrate 11 provided with the porous photoelectrode 13 is immersed in a solution prepared by dissolving a photosensitizing dye 18 in a predetermined solvent, whereby the photosensitizing dye 18 is adsorbed on the porous photoelectrode 13.

On the other hand, a counter electrode 14 is formed, for example, on a counter substrate by sputtering or the like.

Subsequently, the transparent substrate 11 provided with the porous photoelectrode 13 and the counter electrode 14 are so arranged that the porous photoelectrode 13 and the counter electrode 14 face each other, with a predetermined gap therebetween; in this case, the predetermined gap is, for example, 1 to 100 $\mu$m, preferably 1 to 50 $\mu$m. Then, a sealing member 15 is formed along the outer peripheral portions of the transparent substrate 11 and the counter electrode 14, to form a space in which to enclose an electrolyte layer, and an electrolyte layer 16 is formed by pouring (injecting) an electrolyte solution into the space through a pouring port (not shown) preliminarily formed in the transparent substrate 11, for example. Thereafter, the pouring port is sealed off.

Other points than the above-mentioned are the same as in the method of manufacturing a dye-sensitized photoelectric conversion element according to the first embodiment above.

By the steps as above-mentioned, the desired dye-sensitized photoelectric conversion element is manufactured.

The metal-metal oxide particulates 17 constituting the porous photoelectrode 13 can be produced by a known method (see, for example, Jpn. J. Appl. Phys., Vol. 46, No. 4B, 2007, pp. 2567-2570). As an example, a method of manufacturing metal-metal oxide particulates 17 in which the core 17a has Au and the shell 17b has $TiO_2$ will be outlined as follows. First, 500 mL of a heated $5x10^{-4}$ M solution of $HAuC1_4$ is admixed with dehydrated trisodium citrate, and the admixture is stirred. Next, mercaptoundecanoic acid is added to aqueous ammonia in an addition amount of 2.5 wt%, and, after stirring the resulting solution, the solution is added to the dispersion of Au nanoparticles, followed by thermal insulation for 2 hr. Next, the pH of the dispersion is brought to 3 by addition of 1 M HC1. Subsequently, titanium isopropoxide and triethanolamine are added to the Au colloid solution in a nitrogen atmosphere. In this manner, the metal-metal oxide particulates 17 in which the core 17a has Au and the shell 17b has $TiO_2$ are prepared.

[Operation of dye-sensitized photoelectric conversion element]

Now, operation of this dye-sensitized photoelectric conversion element will be described below.

The dye-sensitized photoelectric conversion element, upon incidence of light thereon, operates as a cell with

the counter electrode 14 as a positive electrode and with the transparent electrode 12 as a negative electrode. The principle of operation is as follows. Here, it is assumed that FTO is used as the material for the transparent electrode 12, Au is used as the material for the core 17a of the metal-metal oxide particulates 17 constituting the porous photoelectrode 13, whereas $TiO_2$ is used as the material of the shell 17b of the same, and oxidation-reduction species of $I^-/I_3^-$ is used as the redox couple. It should be noted, however, that this configuration is not limitative.

When a photon transmitted through the transparent substrate 11 and the transparent electrode 12 and incident on the porous photoelectrode 13 is absorbed by the photosensitizing dye 18 bonded to the porous photoelectrode 13, an electron(s) in the photosensitizing dye 18 is excited from a ground start (HOMO) to an excited state (LUMO). The thus excited electron(s) is drawn out into the conduction band of $TiO_2$ constituting the shells 17b of the metal-metal oxide particulates 17 constituting the porous photoelectrode 13, through the electrical coupling between the photosensitizing dye 18 and the porous photoelectrode 13, and passes through the porous photoelectrode 13 to reach the transparent electrode 12. In addition, with light being incident on the surface of the Au core 17a of the metal-metal oxide particulates 17, localized surface plasmon is excited, and an electric field augmenting effect is obtained. By the augmented electric field, a large amount of electrons are excited into the conduction band of $TiO_2$ constituting the shells 17b, and the electrons pass through the porous photoelectrode 13 to reach the transparent electrode 12. Thus, upon incidence of light on the porous photoelectrode 13, not only the electrons which are generated by excitation of the photosensitizing dye 18 but also the electrons which are excited into the conduction band of $TiO_2$ (constituting the shells 17b of the metal-metal oxide particulates 17) due to excitation of the localized surface plasmon at the surfaces of the cores 17a of the metal-metal oxide particulates 17, reach the transparent electrode 12. Consequently, a high photoelectric conversion efficiency can be obtained.

On the other hand, the photosensitizing dye 18 having lost the electron(s) accepts an electron(s) from a reducing agent, for example, $I^-$, in the electrolyte layer 16 through the following reaction, to produce an oxidizing agent, for example, $I_3^-$ (a coupled body of $I_2$ and $I^-$) in the electrolyte layer 16.

$$2I^- \rightarrow I_2 + 2e^-$$

$$I_2 + I^- \rightarrow I_3^-$$

The thus produced oxidizing agent diffuses to reach the counter electrode 14, where it receives an electron(s) from the counter electrode 14 through the reverse reaction (reverse to the above-mentioned reaction), to be reduced to the original reducing agent.

$$I_3^- \rightarrow I_2 + I^-$$

$$I_2 + 2e^- \rightarrow 2I^-$$

The electron(s) sent out from the transparent electrode 12 to an external circuit acts for an electrical work in the external circuit, before returning to the counter electrode 14. In this manner, light energy is converted into electrical energy, without leaving any change in the photosensitizing dye 18 or in the electrolyte layer 16.

According to the second embodiment of the present invention, the merit as follows can be obtained, in addition to the same merit as that of the first embodiment above. The porous photoelectrode 13 has the metal-metal oxide particulates 17 which each has a core-shell structure composed of the spherical core 17a having a metal and the shell 17b having the metal oxide surrounding the core 17a. Therefore, in the case where the electrolyte layer 16 is fillingly disposed between the porous photoelectrode 13 and the counter electrode 14, the electrolyte of the electrolyte layer 16 would not make contact with the metal cores 17a of the metal-metal oxide particulates 17, so that dissolution of the porous photoelectrode 13 by the electrolyte can be prevented. Accordingly, metals having a high surface plasmon resonance effect, such as gold, silver, copper, etc. can be used as the metal constituting the cores 17a of the metal-metal oxide particulates 17. Consequently, the surface plasmon resonance effect can be obtained sufficiently. In addition, an iodine-based electrolyte can be used as the electrolyte of the electrolyte layer 16. As a result of the foregoing, a dye-sensitized photoelectric conversion element showing a high photoelectric conversion efficiency can be obtained. Besides,

by use of the excellent dye-sensitized photoelectric conversion element, a high-performance electronic apparatus can be realized.

<3. Third Embodiment>

[Photoelectric conversion element]

As shown in FIG 19, a photoelectric conversion element according to a third embodiment of the present invention has the same configuration as that of the dye-sensitized photoelectric conversion element according to the second embodiment above, except that the photosensitizing dye 18 is not bonded to the metal-metal oxide particulates 17 constituting the porous photoelectrode 13.

[Method of manufacturing photoelectric conversion element]

The manufacturing method for the photoelectric conversion element in the present embodiment is the same as that for the dye-sensitized photoelectric conversion element according to the second embodiment above, except that the adsorption of the photosensitizing dye 18 on the porous photoelectrode 13 is omitted.

[Operation of photoelectric conversion element]

Now, operation of this photoelectric conversion element will be described below.

The photoelectric conversion element, upon incidence of light thereon, operates as a cell with the counter electrode 14 as a positive electrode and with the transparent electrode 12 as a negative electrode. The principle of operation is as follows. Here, it is assumed that FTO is used as the material of the transparent electrode 12, Au is used as the material of the cores 17a of the metal-metal oxide particulates 17 constituting the porous photoelectrode 13, whereas $TiO_2$ is used as the material of the shells 17b of the metal-metal oxide particulates 17, and oxidation-reduction species of $I^-/I_3^-$ is used as the redox couple. It should be noted here, however, that this configuration is not limitative.

With light transmitted through the transparent substrate 11 and the transparent electrode 12 and incident on the surfaces of the Au cores 17a constituting the metal-metal oxide particulates 17 constituting the porous photoelectrode 13, localized surface plasmon is excited, whereby an electric field augmenting effect is obtained. Then, by the thus augmented electric field, a large amount of electrons are excited into the conduction band of $TiO_2$ constituting the shells 17b, and the electrons pass through the porous photoelectrode 13 to reach the transparent electrode 12.

On the other hand, the porous photoelectrode 13 having lost the electrons accepts an electron(s) from a reducing agent, for example, $I^-$, in the electrolyte layer 16, to produce an oxidizing agent, for example, $I_3^-$ coupled body of $I_2$ and $I^-$), in the electrolyte layer 16.

$$2I^- \rightarrow I_2 + 2e^-$$

$$I_2 + I^- \rightarrow I_3^-$$

The thus produced oxidizing agent diffuses to reach the counter electrode 14, where it receives an electron(s) from the counter electrode 14 through the reverse reaction (reverse to the above-mentioned reaction), to be reduced to the original reducing agent.

$$I_3^- \rightarrow I_2 + I^-$$

$$I_2 + 2e^- \rightarrow 2I^-$$

The electron(s) sent out from the transparent electrode 12 to an external circuit acts for an electrical work in the external circuit, and then returns to the counter electrode 14. In this manner, light energy is converted into electrical

energy, without leaving any change in the electrolyte layer 16.

According to the third embodiment, the same merits as those of the second embodiment can be obtained.

While Embodiments and Examples of the present invention have been specifically described above, the invention is not to be limited to the embodiments and examples, and various modifications are possible based on the technical thought of the invention.

For instance, the numerical values, structures, configurations, shapes, materials and the like mentioned in the Embodiments and Examples above are merely examples, and numerical values, structures, configurations, shapes, material and the like which are different from the above-mentioned may also be used.

The present application contains subject matter related to that disclosed in Japanese Priority Patent Application JP 2010-049765 filed in the Japan Patent Office on March 5, 2010 and Japanese Priority Patent Application JP 2010-160585 filed in the Japan Patent Office on July 15, 2010, the entire content of which are hereby incorporated by reference.

It should be understood by those skilled in the art that various modifications, combinations, sub-combinations and alterations may occur depending on design requirements and other factor in so far as they are within the scope of the appended claims or the equivalents thereof.

Although particular embodiments have been described herein, it will be appreciated that the invention is not limited thereto and that many modifications and additions thereto may be made within the scope of the invention. For example, various combinations of the features of the following dependent claims can be made with the features of the independent claims without departing from the scope of the present invention.

Further particular and preferred aspects of the present invention are set out in the following numbered clauses:

1. The photoelectric conversion element of claim 6, wherein the aromatic ring comprises an aromatic amine.

2. The photoelectric conversion element of clause 1, wherein the aromatic amine is bonded with a hydrogen atom.

3. The photoelectric conversion element of claim 1, wherein the ionic liquid comprises a quaternary ammonium ion comprising at least one of a tetraalkylammonium ion, a pyridinium ion, an imidazolium ion, a thiazolium ion, a pyrazolium ion, or combinations thereof.

4. The photoelectric conversion element of claim 1, wherein the organic solvent comprises at least one of methylamine, dimethylamine, trimethylamine, ethylamine, diethylamine, triethylamine, ethylmethylamine, n-propylamine, iso-propylamine, dipropylamine, n-butylamine, sec-butylamine, tert-butylamine, ethylenediamine, aniline, N,N-dimethylaniline, formamide, N-methylformamide, N,N-dimethylforamide, acetamide, N-methylacetamide, N,N-dimethylacetamide, N-methylpyrrolidone, or combinations thereof.

5. The photoelectric conversion element of claim 1, wherein a volatility of the electrolyte solution comprising a mixture of the ionic liquid and the organic solvent is lower than a volatility of a solution comprising the organic solvent without the ionic liquid.

6. The photoelectric conversion element of claim 1, wherein the electrolyte solution comprises a gel.

7. The photoelectric conversion element of claim 1, further comprising a semiconductor electrode, a counter electrode and a porous photoelectrode, wherein the electrolyte solution and the porous photoelectrode are disposed between the semiconductor electrode and the counter electrode.

8. The photoelectric conversion element of clause 7, further comprising a photosensitizing dye adsorbed onto a surface of the semiconductor electrode.

9. The photoelectric conversion element of clause 7, wherein the porous photoelectrode comprises a plurality of particulates, each particulate having an inner core and an outer shell surrounding the inner core.

10. The photoelectric conversion element of clause 9, wherein the inner core comprises a metal.

11. The photoelectric conversion element of clause 10, wherein the metal comprises at least one of gold, silver, copper, or combinations thereof.

12. The photoelectric conversion element of clause 9, wherein the outer shell comprises a metal oxide.

13. The photoelectric conversion element of clause 12, wherein the metal oxide comprises at least one of titanium oxide, tin oxide, niobium oxide, zinc oxide, tungsten oxide, strontium titanate, or combinations thereof.

14. The photoelectric conversion element of clause 9, wherein an average diameter of the plurality of particulates ranges between 1 and 500 nm.

15. The photoelectric conversion element of clause 9, wherein the plurality of particulates comprises a particulate comprising at least one of a granular, a tubular, a spherical, or a rod-like shape.

## Claims

**1.** A photoelectric conversion element, comprising:

an electrolyte solution comprising an ionic liquid having an electron accepting functional group and an organic solvent having an electron donating functional group.

**2.** The photoelectric conversion element of claim 1, wherein the electron accepting functional group comprises an electron pair accepting functional group.

**3.** The photoelectric conversion element of claim 1, wherein the electron donating functional group comprises an electron pair donating functional group.

**4.** The photoelectric conversion element of claim 1, wherein the electron accepting functional group is adapted to form at least one hydrogen bond with the electron donating functional group.

**5.** The photoelectric conversion element of claim 1, wherein the ionic liquid comprises an organic cation.

**6.** The photoelectric conversion element of claim 5, wherein the organic cation comprises an aromatic ring.

**7.** The photoelectric conversion element of claim 1, wherein the ionic liquid comprises at least one of 1-ethyl-3-methylimidazolium tetracyanoborate, 1-ethyl-3-methylimidazolium bis(trifluoramethanesulfone)imide, 1-ethyl-3-methylimidazolium tris(pentafluoraethyl)trifluorophosphate, 1-ethyl-3-methylimidazolium tetrafluoroborate, or combinations thereof.

**8.** The photoelectric conversion element of claim 1, wherein the ionic liquid comprises an anion having a van der Waals volume of at least 76 Å3.

**9.** The photoelectric conversion element of claim 1, wherein the ionic liquid comprises at least 15 wt% of the electrolyte solution.

**10.** The photoelectric conversion element of claim 1, wherein the ionic liquid comprises between about 15 wt% and about 50 wt% of the electrolyte solution.

**11.** The photoelectric conversion element of claim 1, wherein the organic solvent comprises a functional group comprising at least one of an ether, a ketone, an amine, a pyridine structure, an imidazole structure, a sulfone, or a sulfoxide.

**12.** The photoelectric conversion element of claim 11, wherein the amine comprises at least one of a primary amine, a tertiary amine, or an aromatic amine.

**13.** The photoelectric conversion element of claim 1, wherein the organic solvent comprises at least one of 3-methoxypropionitrile, γ-butyrolactone, N,N-dimethylformamide, diethylene glycol dimethyl ether, triethylene glycol dimethyl ether, tetraethylene glycol dimethyl ether, phenoxy acetonitrile, propylene carbonate, aniline, N,N-dimethylaniline, N-butylbenzimidazole, tert-butylpyridine, ethyl methyl sulfone, dimethyl sulfoxide, or combinations thereof.

**14.** An electrolyte solution comprising an ionic liquid having an electron accepting functional group and an organic solvent having an electron donating functional group.

FIG. 1

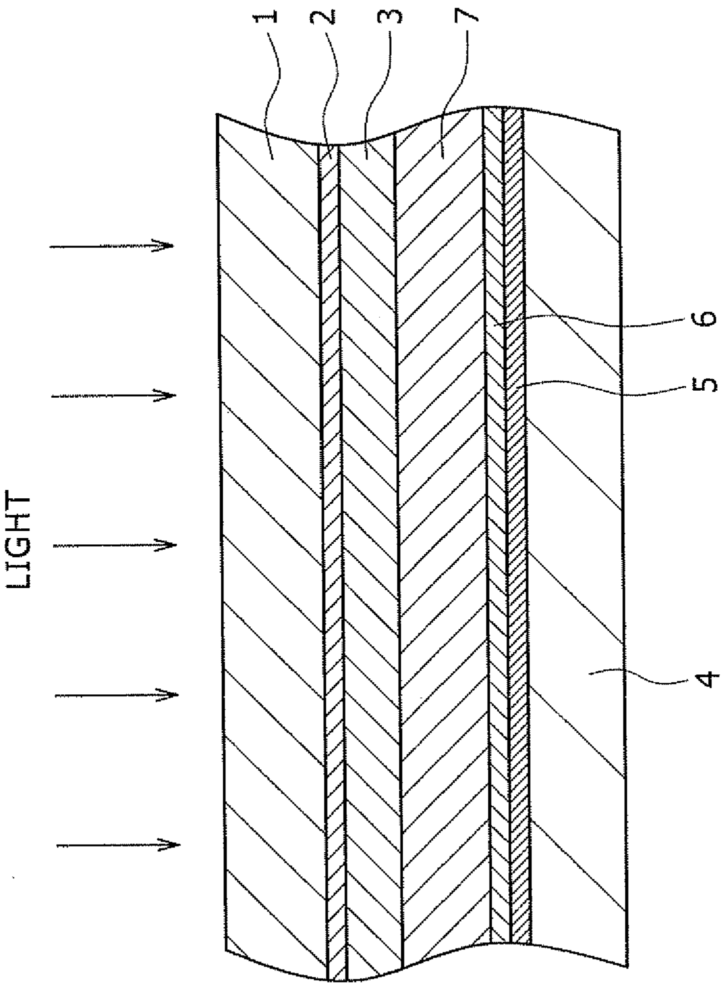

FIG. 2

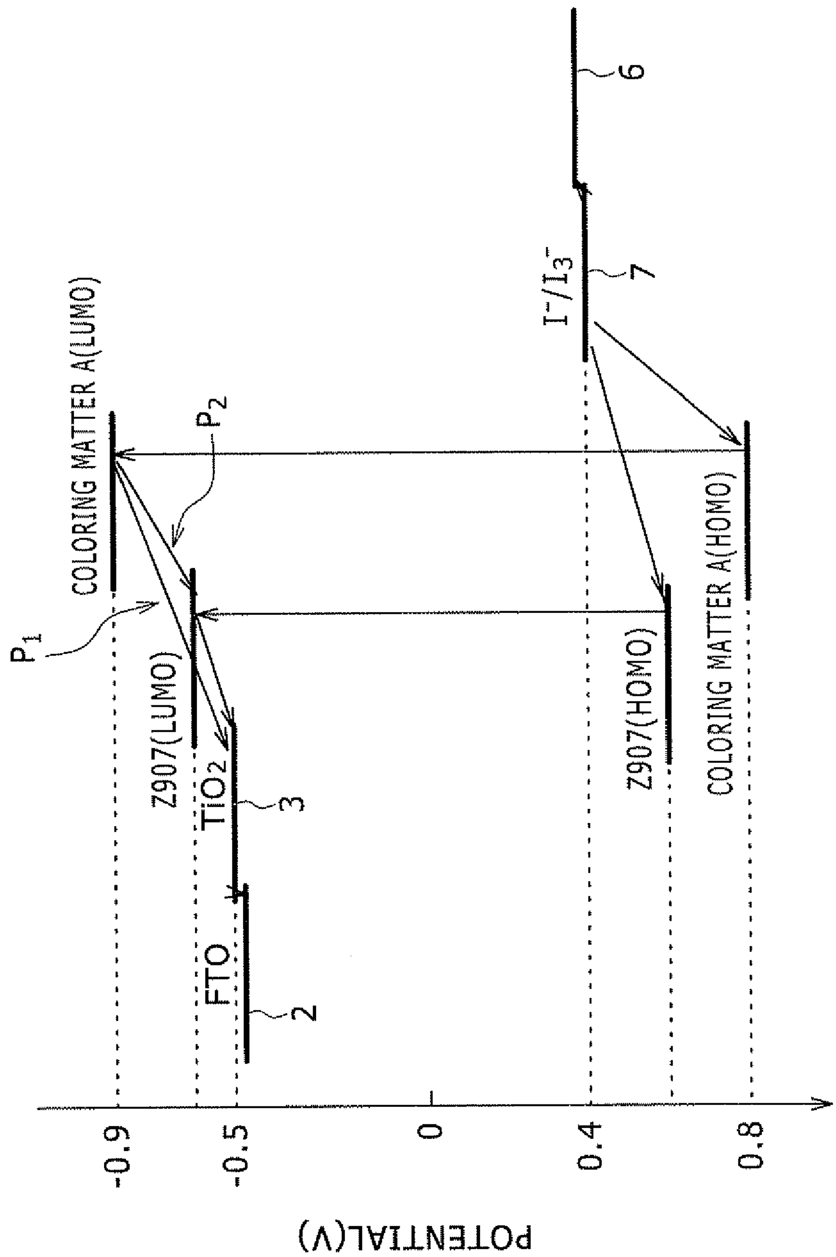
COLORING MATTER A(LUMO)
P1
P2
Z907(LUMO)
TiO2
3
FTO
2
I⁻/I3⁻
7
6
Z907(HOMO)
COLORING MATTER A(HOMO)
-0.9
-0.5
0
0.4
0.8
POTENTIAL(V)

FIG.3

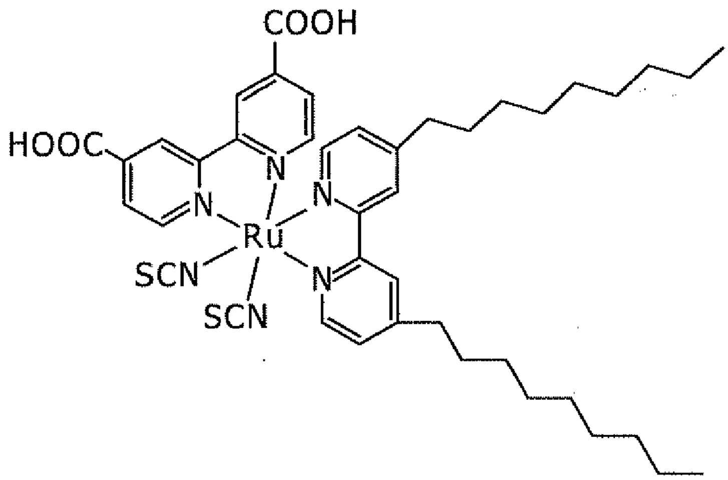

FIG.4

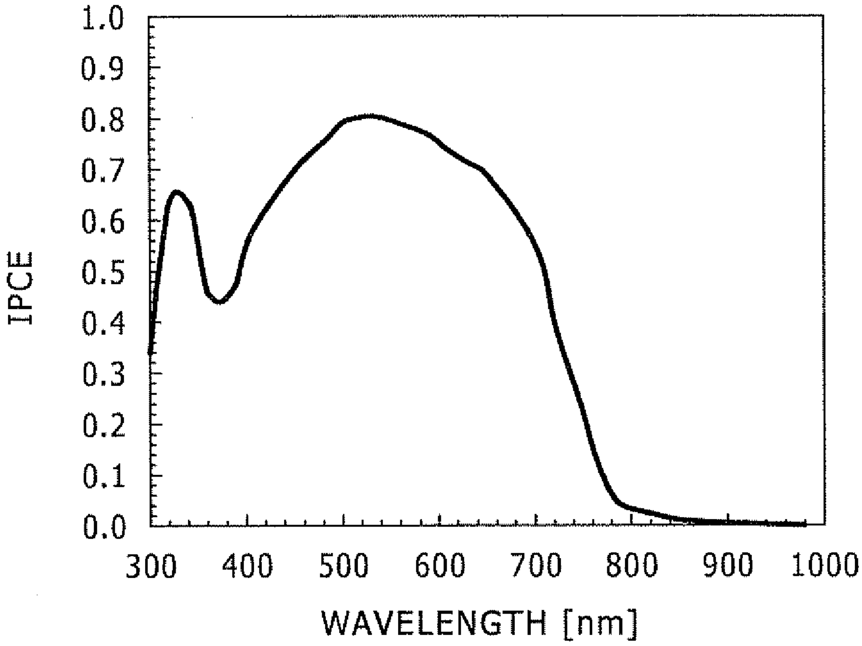
1.0
0.9
0.8
0.7
0.6
0.5
0.4
0.3
0.2
0.1
0.0
IPCE
300
400
500
600
700
800
900
1000
WAVELENGTH [nm]

FIG.5

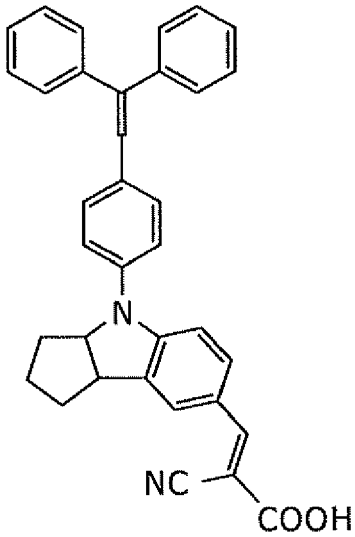

FIG.6

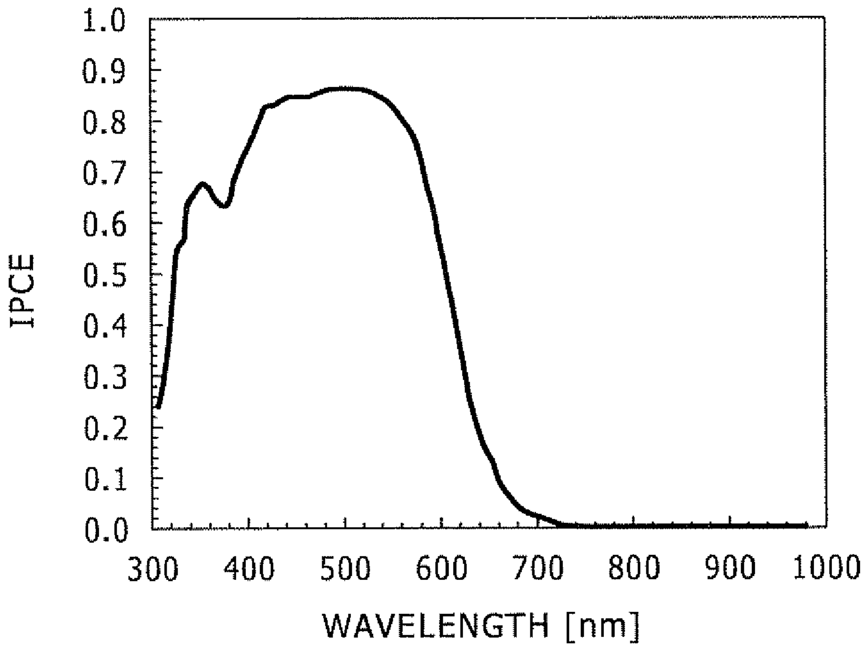
IPCE
1.0
0.9
0.8
0.7
0.6
0.5
0.4
0.3
0.2
0.1
0.0
300
400
500
600
700
800
900
1000
WAVELENGTH [nm]

FIG. 7

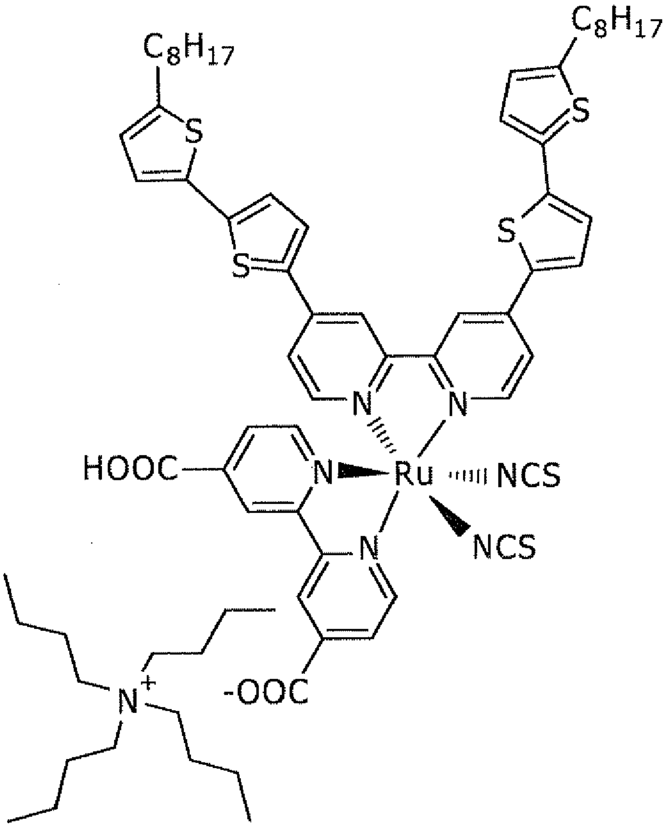

FIG.8

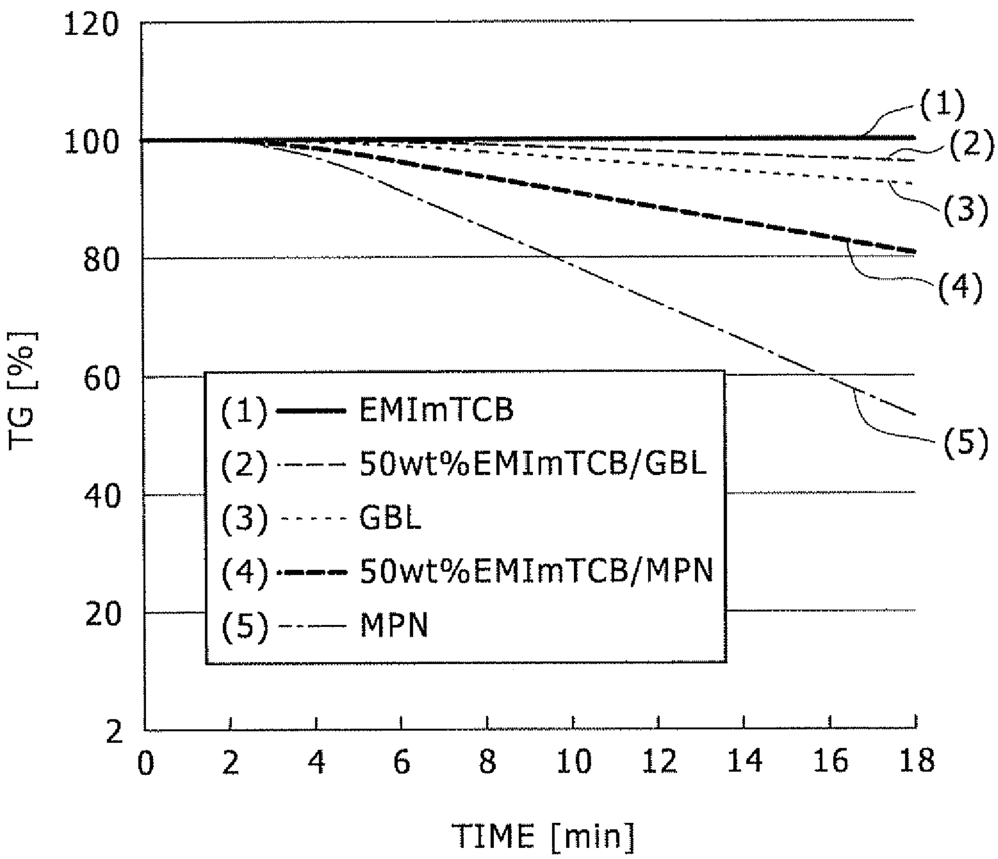
120
100
80
60
40
20
2
TG [%]
0
2
4
6
8
10
12
14
16
18
TIME [min]
(1)
(2)
(3)
(4)
(5)
(1) EMImTCB
(2) 50wt%EMImTCB/GBL
(3) GBL
(4) 50wt%EMImTCB/MPN
(5) MPN

FIG. 9

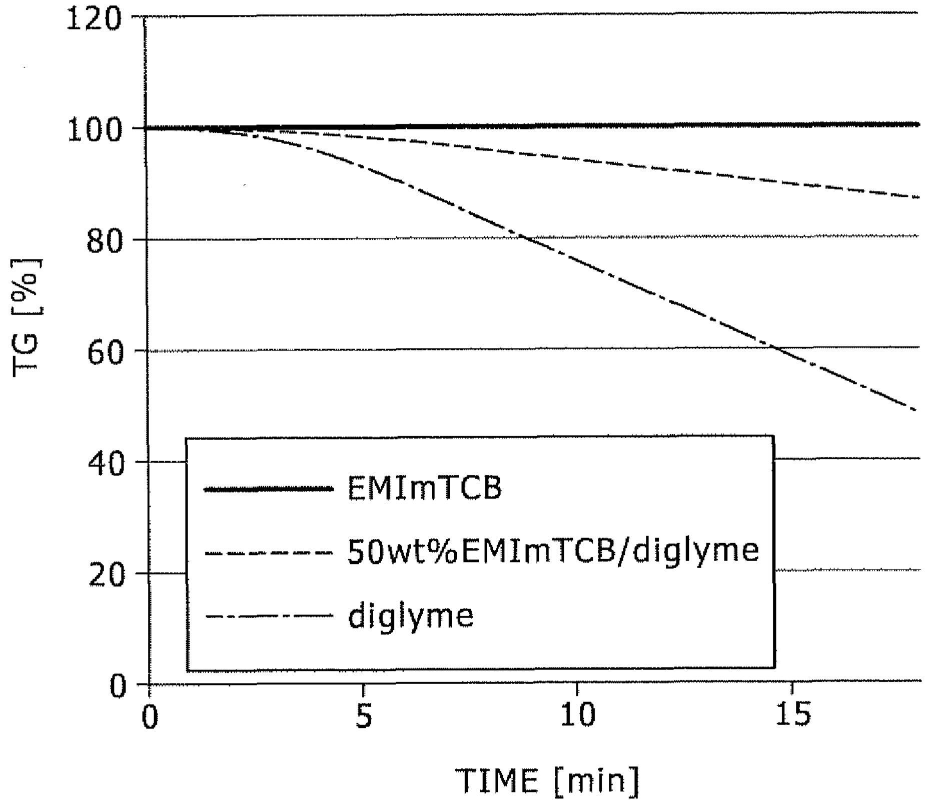
120
100
80
60
40
20
0
TG [%]
0
5
10
15
TIME [min]
EMImTCB
50wt%EMImTCB/diglyme
diglyme

FIG.10

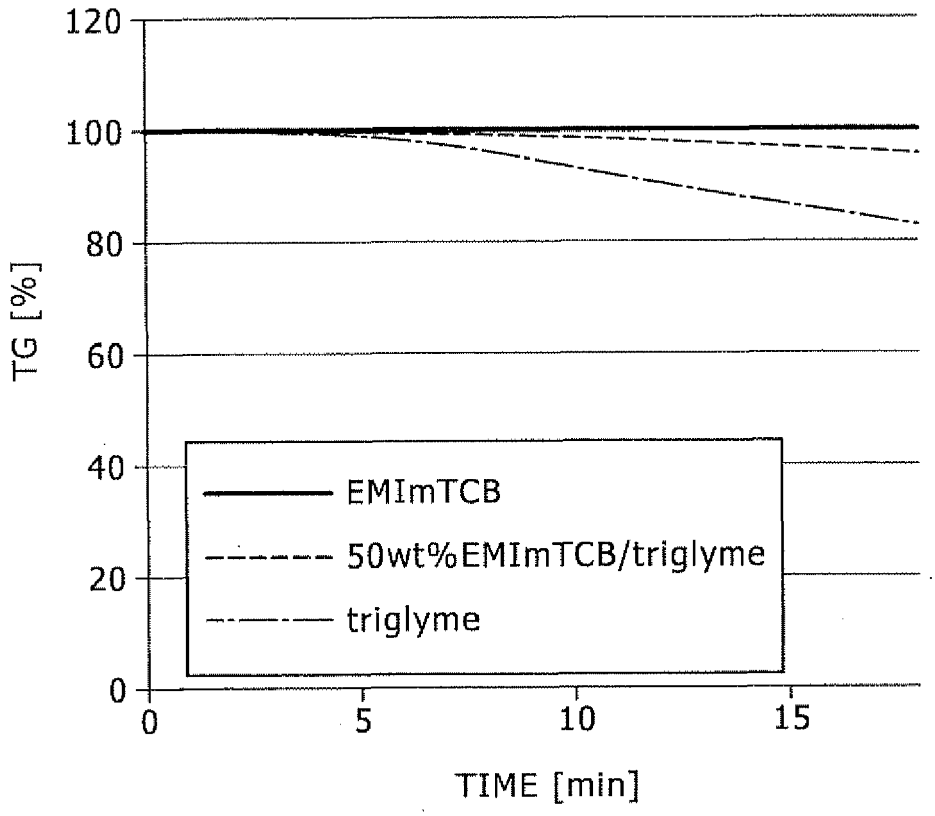
120
100
80
60
40
20
0
TG [%]
0
5
10
15
TIME [min]
EMImTCB
50wt%EMImTCB/triglyme
triglyme

FIG.11

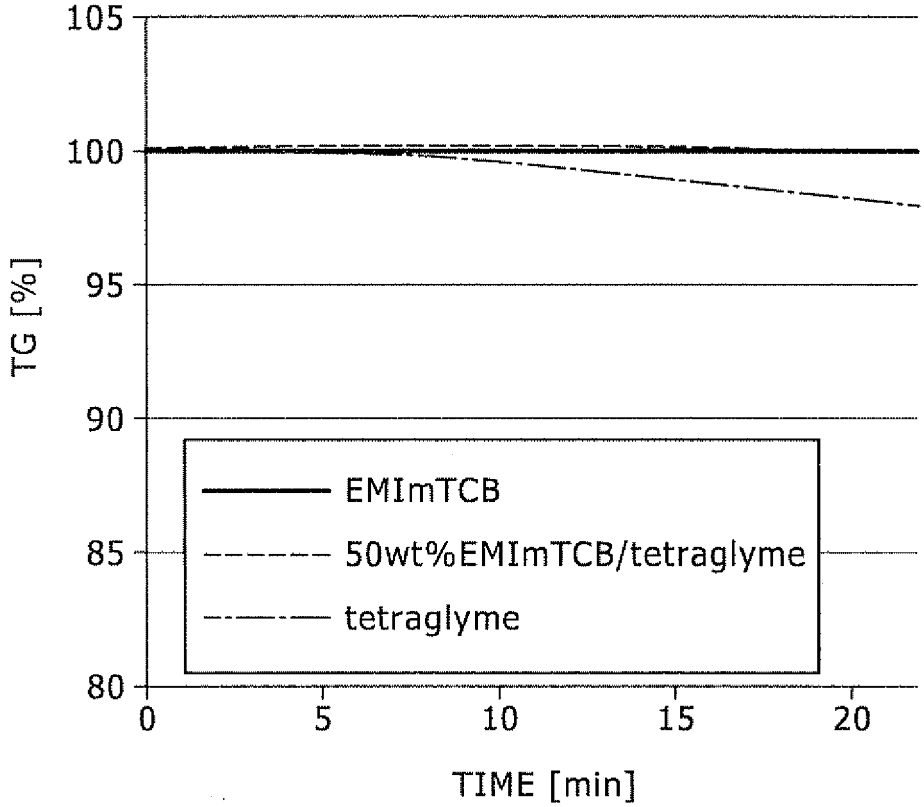
105
100
95
90
85
80
TG [%]
0
5
10
15
20
TIME [min]
EMImTCB
50wt%EMImTCB/tetraglyme
tetraglyme

FIG. 12

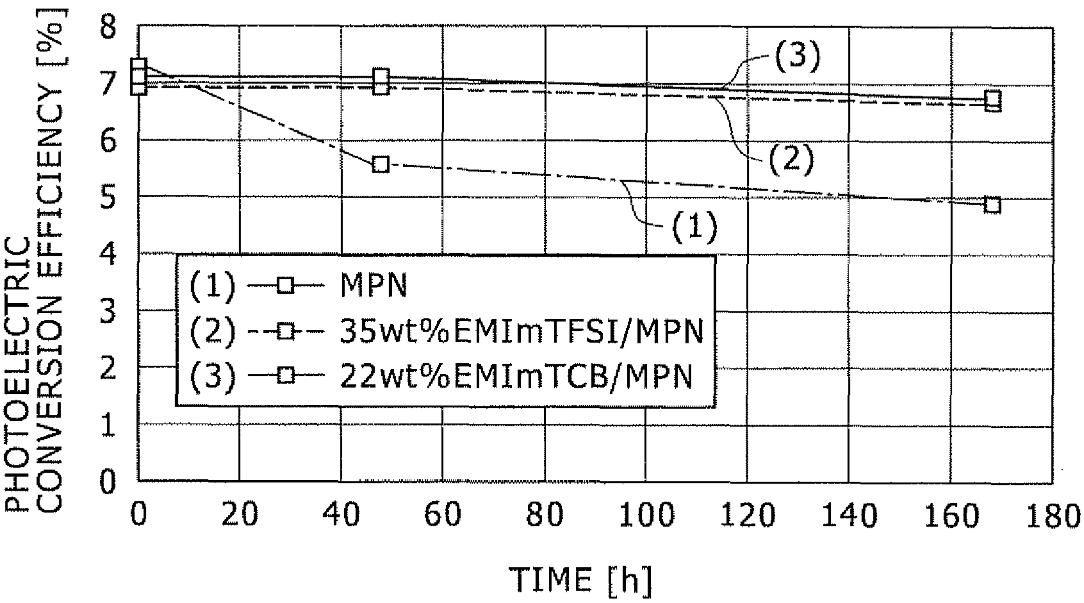
PHOTOELECTRIC CONVERSION EFFICIENCY [%]
8
7
6
5
4
3
2
1
0
0
20
40
60
80
100
120
140
160
180
TIME [h]
(3)
(2)
(1)
(1) MPN
(2) 35wt%EMImTFSI/MPN
(3) 22wt%EMImTCB/MPN

FIG.13

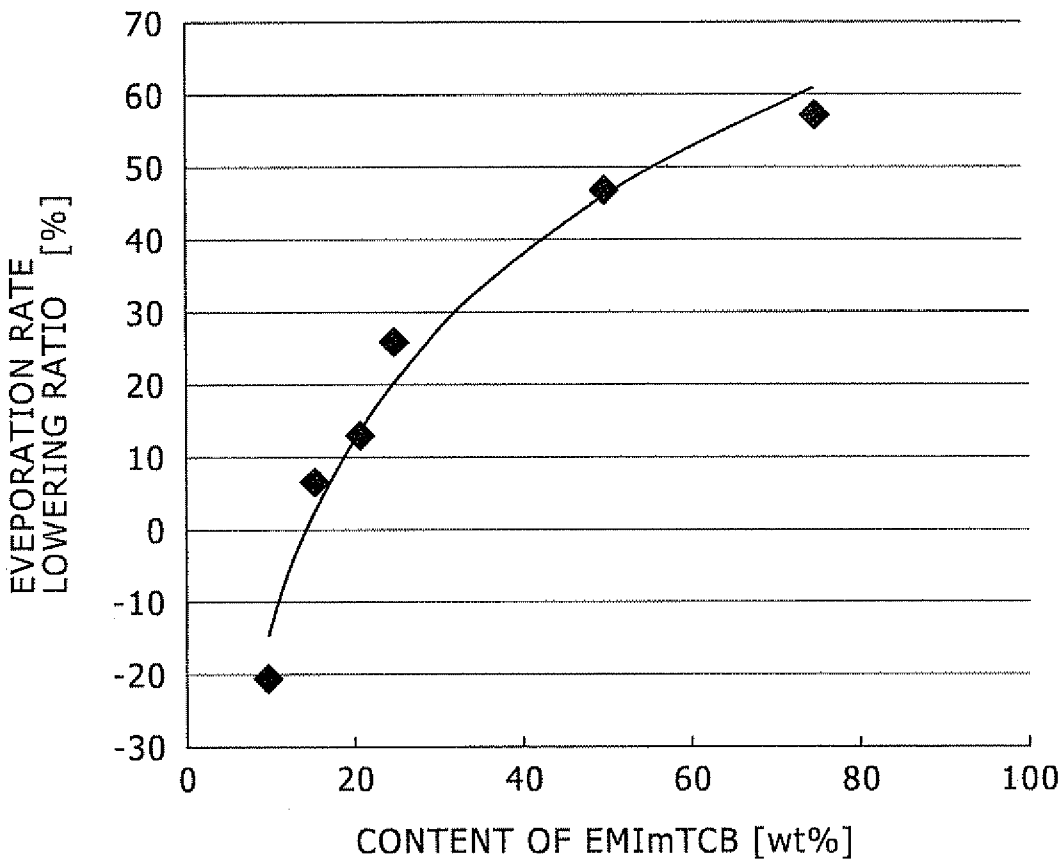
70
60
50
40
30
20
10
0
-10
-20
-30
EVEPORATION RATE
LOWERING RATIO [%]
0
20
40
60
80
100
CONTENT OF EMImTCB [wt%]

FIG.14

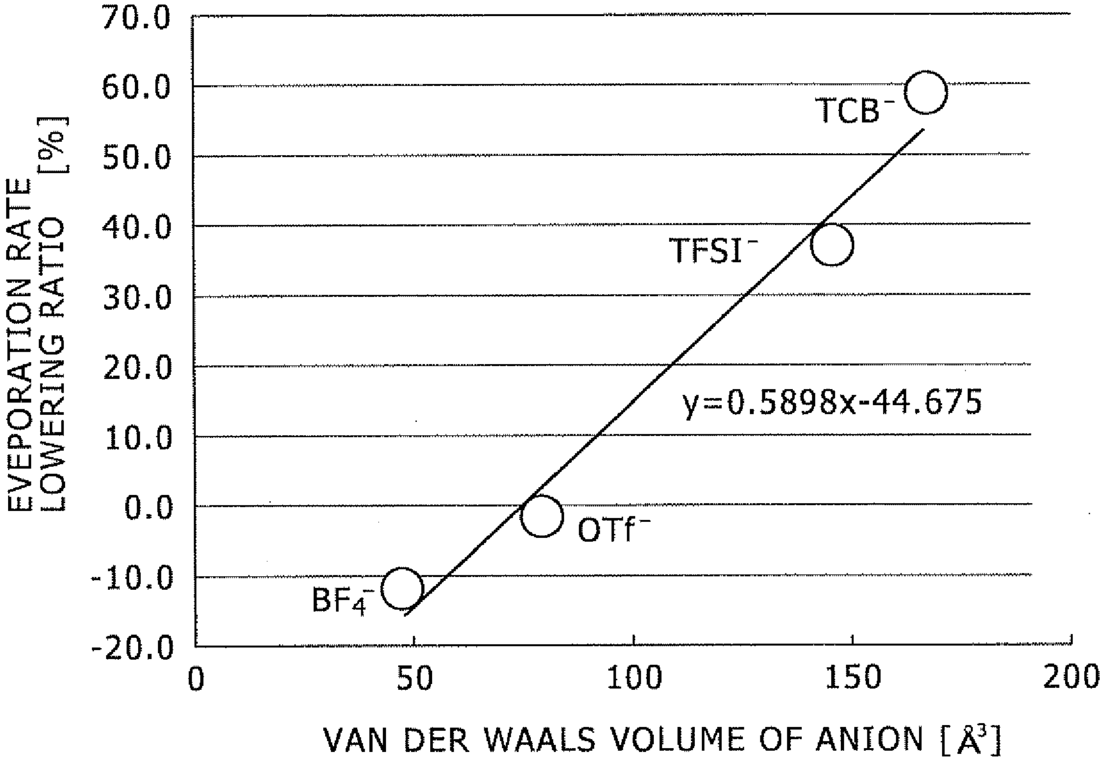

70.0
60.0
50.0
40.0
30.0
20.0
10.0
0.0
-10.0
-20.0
EVEPORATION RATE LOWERING RATIO [%]
TCB⁻
TFSI⁻
y=0.5898x-44.675
OTf⁻
BF4⁻
0
50
100
150
200
VAN DER WAALS VOLUME OF ANION [Å3]

FIG.15

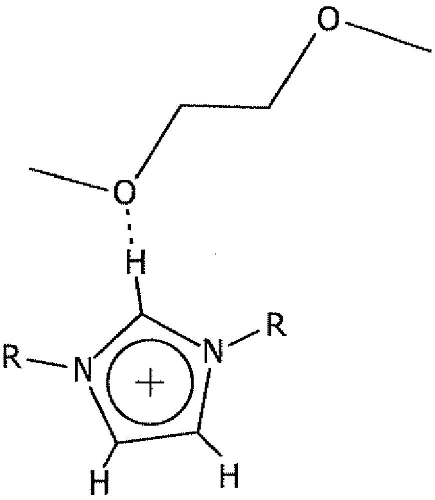

FIG.16

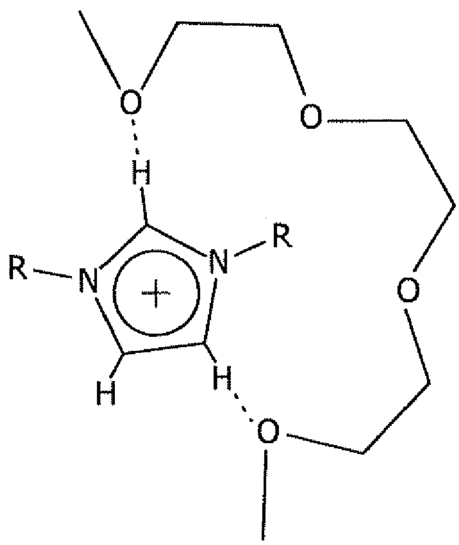

FIG.17

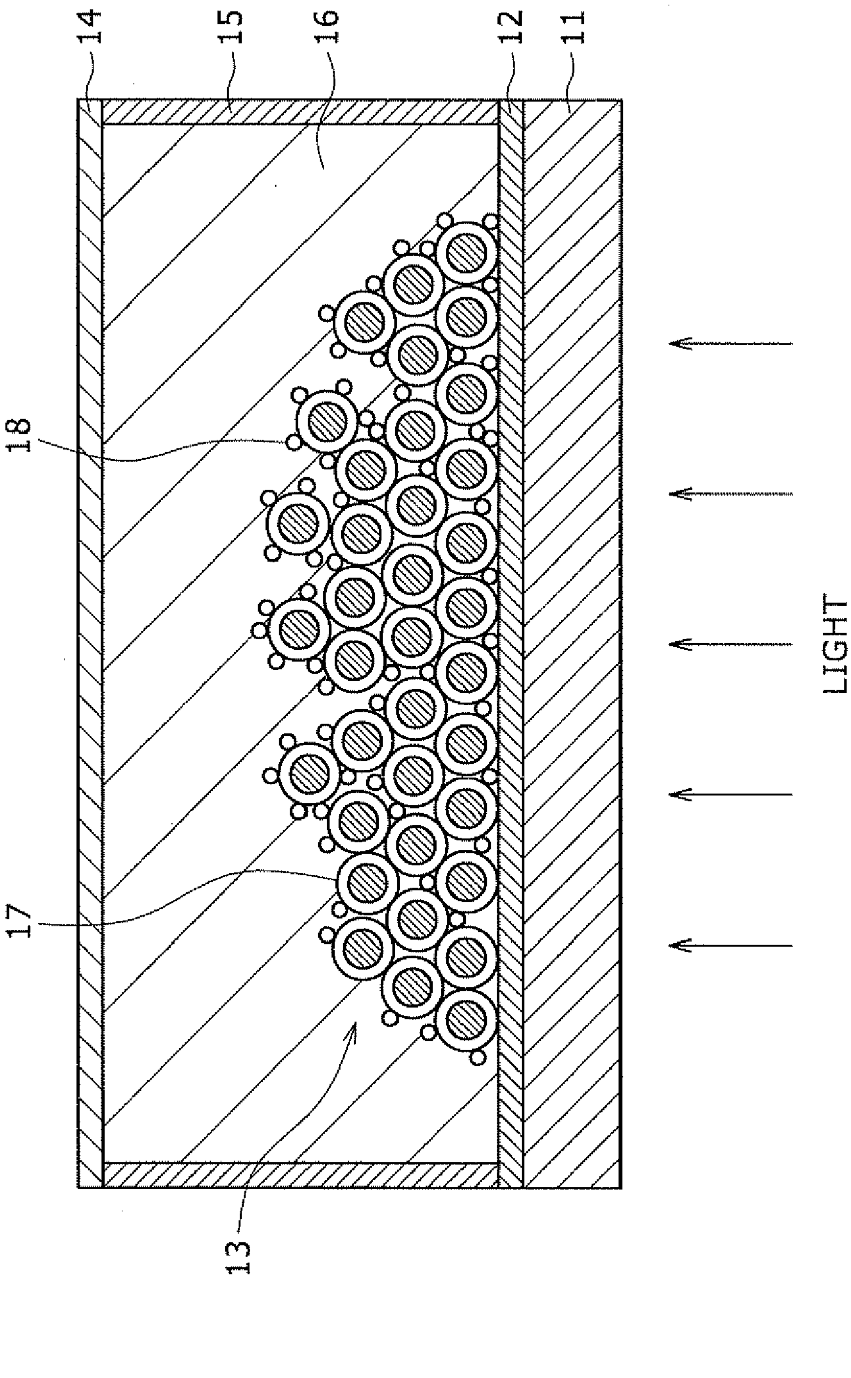

FIG.18

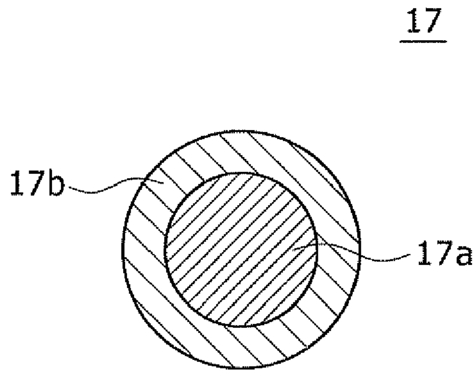

FIG.19

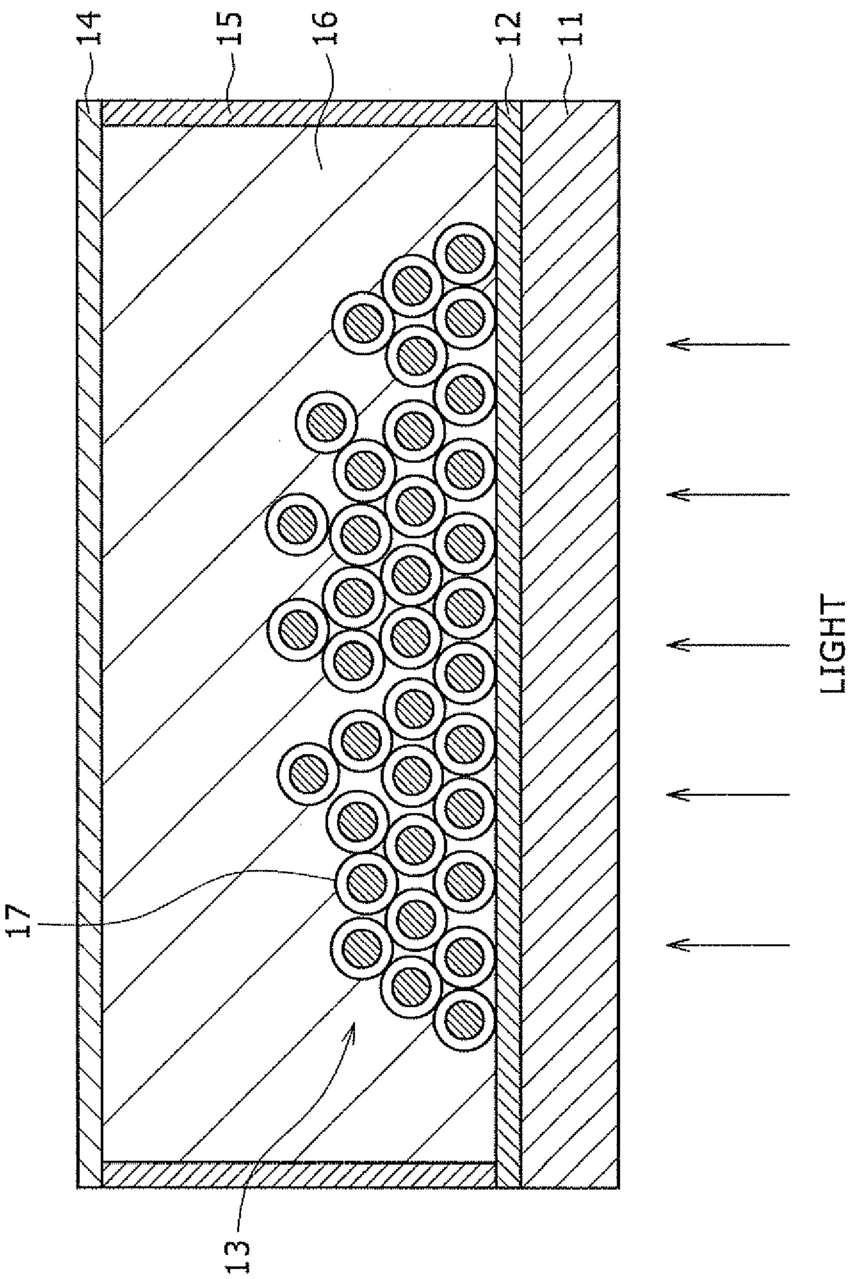

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2009527074 T
- JP 2010049765 A
- JP 2010160585 A

### Non-patent literature cited in the description


- *Nature,* 1991, vol. 353, 737-740
- *Inorg. Chem.,* 1996, vol. 35, 1168-1178
- *J. Chem. Phys.,* 2006, vol. 124, 184902
- **HIRONORI ARAKAWA.** The Latest Technologies of Dye-Sensitized Solar Cells. CMC Publishing Co., Ltd, 2001
- *Journal of The Electrochemical Society 002,* 2002, vol. 149 (10), A1385-A1388
- *Jpn. J. Appl. Phys.,* 2007, vol. 46 (4B), 2567-2570